# EUROPÄISCHE PATENTSCHRIFT

(11) **EP 3 108 286 B1**
(45) Veröffentlichungstag und Bekanntmachung des Hinweises auf die Patenterteilung: **10.01.2024**
(21) Anmeldenummer: 15705502.1
(22) Anmeldetag: 18.02.2015
(51) Int. Cl.: G02B 26/02, H10K 50/00, G02F 1/1335

(54) **ANZEIGEVORRICHTUNG**
DISPLAY DEVICE
DISPOSITIF D'AFFICHAGE

(30) Priorität: 19.02.2014 DE 102014002272; 30.06.2014 DE 102014009677; 03.12.2014 DE 102014017764
(43) Veröffentlichungstag der Anmeldung: 28.12.2016
(73) Patentinhaber: PA.Cotte Family Holding GmbH, 92224 Amberg (DE)
(72) Erfinder: Cotte, Pierre-Alain, 92224 Amberg (DE)
(74) Vertreter: reuteler & cie SA
(86) Internationale Anmeldenummer: PCT/EP2015/000355
(87) Internationale Veröffentlichungsnummer: WO 2015/124292

(56) Entgegenhaltungen:
- WO-A1-2005/059636
- WO-A2-93/18428
- JP-A- 2008 134 318
- US-A1- 2004 051 447
- US-A1- 2007 085 471

## Beschreibung

Die Erfindung betrifft eine Farbanzeigevorrichtung mit einer Anzeigefläche mit mehreren Pixeln. Solche Anzeigevorrichtungen sind im Stand der Technik z.B. als LCD-Anzeigevorrichtungen oder OLED-Anzeigevorrichtungen bekannt. Nachteilig an solchen Anzeigevorrichtungen ist der begrenzte Kontrastumfang, den diese Anzeigevorrichtungen aufweisen. Die US 2008/0024470 zeigt ein unsichtbares, lichtdurchlässiges Anzeigesystem, in einem lichtundurchlässigen Material. Im Wesentlichen unsichtbare, verjüngte, lichtdurchlässige Löcher sind in einem lichtdurchlässigen Muster durch zumindest einen Teil des lichtbeständigen Materials unter Verwendung eines Laserstrahls mit einer Brennweite kleiner als der kleinste Durchmesser der kegelförmigen Löcher durchsetzt. Die Hauptzielrichtung besteht in einer Anwendung als LED-Indikatoren, z.B. für Batterie oder Stand-By-Lichtsignale, die unsichtbar in ein Material integriert werden sollen, wobei die Löcher an sich sehr klein sein sollen, und der Abstand zwischen den Löchern an das Auflösungsvermögen des Betrachters angepasst ist.

Die US 2007/085471 betrifft eine Vorrichtung mit organischer Leuchtdiode (OLED), umfassend eine erste Elektrode und eine zweite Elektrode mit einer oder mehreren dazwischen gebildeten organischen Schichten, wobei mindestens eine organische Schicht lichtemittierend ist, wobei die erste und die zweite Elektrode einen oder mehrere lichtemittierende Bereiche definieren, und wobei mindestens eine der ersten und zweiten Elektroden reflektierende und transparente Abschnitte in dem lichtemittierenden Bereich umfasst.

Ein weiteres Farbanzeigesystem ist in der US 2004/051447 A1 offenbart.

Aufgabe der vorliegenden Erfindung ist es, Farbanzeigevorrichtungen der erst genannten Art, d.h. Anzeigevorrichtung mit einer Anzeigefläche mit mehreren Pixeln, z.B. LCD- oder OLED-Anzeigevorrichtungen, zu verbessern, insbesondere die Anzeigequalität und/oder den visuellen Eindruck einer solchen Anzeige zu verbessern und/oder die Anzeigevorrichtung energieeffizienter zu gestalten und/oder die Anzeigevorrichtung für weitere Anwendungen zu erweitern.

Die Aufgabe wird durch den unabhängigen Anspruch gelöst. Vorteilhafte Weiterbildungen sind in den Unteransprüchen definiert.

Insbesondere wird die Aufgabe gelöst durch eine Farbanzeigevorrichtung mit einer Anzeigefläche bestehend aus nicht leuchtenden Flächen und Leuchtflächen, wobei die Flächenschwerpunkte benachbarter Leuchtflächen gegenseitige Abstände aufweisen, die kleiner sind, als das Auflösungsvermögen eines Betrachters und wobei vorzugsweise der Anteil der nicht leuchtenden Flächen an der gesamten Anzeigefläche mehr als 70% beträgt.

Hierdurch wird zunächst eine Farbanzeigevorrichtung bereitgestellt, welche auf bekannte Weise so hochauflösend ist, dass der menschliche Betrachter die einzelnen Leuchtflächen nicht voneinander unterscheiden kann. Darüberhinaus wird jedoch ein besonderer Vorteil durch eine bewusste und dem allgemeinen Bestreben einer Leuchtflächenmaximierung genau entgegengesetzte Verkleinerung des Anteils der Leuchtflächen an der Anzeigefläche und eine Vergrößerung der nicht leuchtenden Flächen zwischen den Leuchtflächen erhalten. Hierdurch werden dunkle Bereiche dann auch in der Tat dunkel bleiben können, da sie im Verhältnis viel größer als die leuchtenden Flächen sind, noch verstärkt z.B. bei einem Anteil der nicht leuchtenden Flächen von z.B. mehr als 95% (ein bevorzugtes Merkmal dieser Erfindung, siehe unten), und weniger lichtreflektierend sind, was insbesondere vorteilhaft ist in dunkleren Teilen des Bildes und/oder bei starkem Umgebungslicht. Das wiederum bringt ein großes Stromersparnis-Potential mit sich, da weniger Licht notwendig ist, um einen guten Kontrastwert zu erreichen (bei vorhandenem Umgebungslicht). Weiterhin wird eine zusätzliche Kontrasterhöhung erzielt, da zwischen den einzelnen Leuchtflächen ein größere Trennung durch nicht leuchtende Flächen vorhanden ist und somit einerseits kein oder nur ein wesentlich reduzierter Leucht-"Crosstalk" zwischen benachbarten Leuchtflächen erfolgt.

Unter einer Farbanzeigevorrichtung bzw. einem Display wird eine Einrichtung verstanden, welche eingerichtet ist, bevorzugt digitale oder digitalisierte Bilder, Text, Graphik oder Video, welche jeweils aus einzelnen Pixeln zusammengesetzt ist, anzuzeigen. Z.B. ist sie ein Display eines Handheld-Devices (z.B. Mobilfunkgerät/Smartphone, Armband/Taschenuhr, Pocket-Mediaplayer, Tablet etc.), eines konventionellen Computers (Laptop, Desktop etc.), eines Fernsehers oder einer Werbe-/Informationsanzeigetafel (z.B. in U-Bahnen, Sportstadien oder Kaufhäuser, an Hauswänden etc.).

Die Anzeigefläche ist eine dem Betrachter zugewandte Fläche der Anzeigevorrichtung, innerhalb welcher die einzelnen Pixel angeordnet sind. Die Anzeigefläche ist bevorzugt begrenzt durch eine (imaginäre) Linie, welche entlang der äußersten Pixel, bevorzugt entlang der äußersten Leuchtflächen der Anzeigevorrichtung verläuft. Bevorzugt verläuft um die Anzeigefläche herum in der Regel ein Rahmen, welcher z.B. für mechanische Stabilität sorgt, der jedoch umso vorteilhafter für z.B. das Design ist, je dünner er ist. Unter Leuchtfläche wird eine Fläche verstanden, von welcher aus in einem eingeschaltetem Modus Lichtstrahlen zu dem Betrachter ausgehen. Die Lichtstrahlen können entweder direkt in der Fläche generiert bzw. ausgesendet werden (z.B. durch eine in der Leuchtfläche angeordnete aktive Lichtquelle wie einer LED) oder sie können durch die Leuchtfläche zu dem Betrachter weitergeleitet werden (Hintergrundbeleuchtung wie bei LCD Bildschirmen). Die Fläche erststreckt sich bevorzugt teilweise oder ganz durch Luft bzw. einen körperlosen Bereich. Dabei ist sie bevorzugt durch einen Rahmen oder eine Maske umrahmt. Vereinfacht dargestellt, kann eine Leuchtfläche also ein Loch bzw. eine Bohrung sein, welche Licht bzw. Lichtstrahlen eine Öffnung bietet, von welcher aus die Lichtstrahlen zu dem Betrachter gelangen. Besonders bevorzugt besteht die Fläche teilweise oder ganz aus einem zumindest teilweise oder zu einem bestimmten Grad oder komplett transparenten Festkörper oder verläuft teilweise oder ganz durch diesen. Z.B. sind die Leuchtflächen diejenigen Flächen der Anzeigevorrichtung welche die Subpixel darstellen und bei einem Leuchten der Subpixel das Licht an den Betrachter ausstrahlen. Die Form der Leuchtfläche ist beliebig, bevorzugt viereckig oder rund. Bevorzugt ist mindestens eine Leuchtflächenform in gleichmäßiger Wiederholung identisch vorhanden. Eine Leuchtfläche ist bevorzugt einem Pixel zugeordnet. Ferner ist es günstig, wenn ein Pixel oder ein Subpixel, beispielsweise RGB-Subpixel, mehrere Leuchtflächen aufweist. Auf diese Weise kann die Lichtintensität sowie die Farbdarstellung feinstufiger realisiert werden. Des Weiteren ist es bevorzugt, dass ein Pixel mindestens zwei Leuchtflächen aufweist, sodass eine Lichtabstrahlung in mehrere Raumrichtungen, vorzugsweise in entgegengesetzte Richtungen, realisierbar ist. Auf diese Weise kann z. B. eine Anzeigefläche einer Anzeigevorrichtung mehrere Anzeigeflächen dem Betrachter zur Verfügung stellen, sodass beispielsweise ein Tablet-Computer auf jeder Seite bzw. auf der Ober- und Unterseite ein Display aufweist, um die Handhabung noch weiter zu vereinfachen. Selbstverständlich können auch weitere dem Betrachter zugewandte Flächen Licht an diesen senden. Auch in diesem Zusammenhang wird unter einer Leuchtfläche eine Fläche verstanden, von welcher aus in einem eingeschaltetem Modus Lichtstrahlen zu dem Betrachter ausgehen.

Unter einer nicht leuchtenden Fläche werden Bereiche verstanden, welche zwischen den Leuchtflächen vorhanden sind und welche von sich aus nicht leuchten oder hinterleuchtet sind. Bevorzugt ist eine oder sind alle nicht leuchtenden Flächen zu mindestens 90 % lichtundurchlässig.

Der Flächenschwerpunkt einer Leuchtfläche ist der geometrische Schwerpunkt oder Schwerpunkt der Fläche, welcher mathematisch der Mittelung aller Punkte innerhalb der Fläche entspricht.

Abstände, die kleiner sind als das Auflösungsvermögen eines Betrachters, sind bevorzugt derart, dass die Pixel oder Leuchtflächen so nahe zusammen angeordnet sind, dass ein Betrachter, dessen Augen sich bevorzugt in einem Abstand zu der Anzeigevorrichtung befinden, welcher für die konkrete Art der Anzeigevorrichtung bei der Benutzung der Anzeigevorrichtung üblich ist, zwei benachbarte Pixel oder Leuchtflächen nicht mehr voneinander unterscheiden kann.

Bevorzugt sind die Abstände, die kleiner sind als das Auflösungsvermögen des Betrachters, solche Abstände, die bei dem Betrachter unter einem Winkel von maximal zwei Winkelminuten erscheinen. Hierdurch sind die Pixel oder Leuchtflächen für einen Großteil der Betrachter nicht mehr unterscheidbar, da das menschliche Auflösungsvermögen in ungünstigen Fällen in etwa 2 Winkelminuten entspricht. Besonders bevorzugt erscheinen die Abstände dem Betrachter maximal unter einem Winkel von 1 Winkelminute, besonders bevorzugt 0,5 Winkelminuten, besonders bevorzugt 0,25 Winkelminuten. Hierdurch sind für nahezu alle menschlichen Betrachter die Pixel oder Leuchtflächen nicht mehr unterscheidbar. Je kleiner der maximale Winkel, desto weniger Betrachter existieren, deren Sehfähigkeit zur Unterscheidung zweier Pixel oder Leuchtflächen ausreicht.

Bevorzugt weist das oder weisen die Augen des Betrachters einen Abstand zu der Anzeigefläche auf, welche für die konkrete Art der Anzeigevorrichtung bei der Benutzung der Anzeigevorrichtung üblich ist. Zum Beispiel beträgt der Abstand 5 cm bis 1,20 m, bevorzugt 15 cm bis 60 cm für Displays von Handheldgeräten (Mobiltelefon, Uhr, Tablet-Computer), 25 cm bis 2 m, bevorzugt 40 cm bis 1 m für Displays von Desktop-Computer, 1 m bis 7 m bevorzugt 2 m bis 5 m für Fernsehgeräte und/oder 2 m bis 100 m, bevorzugt 5 m bis mehr als 100 m für Werbe-/Informationsanzeigetafeln. Besonders bevorzugt sind die Abstände, die kleiner als das Auflösungsvermögen des Betrachters sind, kleiner als 1 mm, wobei dies z.B. ein Abstand im Falle eines Fernsehers ist, bei dem der Benutzer in üblicher Betrachtungsentfernung (> 2m) die einzelnen Pixel oder Leuchtflächen dann nicht mehr voneinander unterscheiden kann.

Z.B. ist die Anzeigevorrichtung ein Desktop-Computer mit einer minimalen Nutzerdistanz (bezogen auf das Auge) von 50 cm. In der hypothetischen Annahme, dass z.B. 70% der potentiellen Benutzer über kein besseres Auflösungsvermögen als 0,6 Winkelminuten verfügen, werden die Pixel oder Leuchtflächen der Anzeigevorrichtung kleiner gleich 87 µm, bevorzugt 80 µm) für einen Sicherheitspuffer, voneinander beabstandet, damit für zumindest 70% der Benutzer bei der üblichen Benutzung der Anzeigevorrichtung eine besonders hochwertige Darstellung ermöglicht wird, da für sie einzelne Leuchtflächen nicht unterscheidbar sind. Es resultiert eine Auflösung der Anzeigevorrichtung von 317 DPI, bevorzugt 320 DPI mit Sicherheitspuffer.

Erfindungsgemäß betragen die Abstände, die kleiner als das Auflösungsvermögen des Betrachters sind, maximal 190 µm, bevorzugt maximal 80 µm, besonders bevorzugt maximal 50 µm. Hierdurch wird erreicht, dass, auch wenn der Betrachter der Anzeigefläche näher als üblich kommt, er einzelne Pixel oder Leuchtflächen nicht voneinander unterscheiden kann. Je nach Auflösungsvermögen und Akkommodationsfähigkeit des individuellen Betrachters ist es damit sogar egal wie nahe der individuelle Betrachter der Anzeigevorrichtung kommt, denn er kann selbst bei optimaler Ausnutzung seiner Sehkraft und einem Annähern bis an die Naheinstellgrenze seines Auges nicht die einzelnen Pixel oder Leuchtflächen voneinander unterscheiden.

Bevorzugt beträgt die Ausdehnung einer, bevorzugt jeder, Leuchtfläche höchstens 70 µm, bevorzugt höchstens 25 µm, besonders bevorzugt höchstens 10 µm oder sogar höchstens 5 µm. Hierdurch wird erreicht, dass der Betrachter Leuchtflächen mit bloßem Auge (in ausgeschaltetem Zustand) nicht erkennen kann und der Kontrast höher wirkt. Die Ausdehnung ist bevorzugt eine Ausdehnung, bevorzugt die maximale Ausdehnung, einer Leuchtfläche parallel zur Anzeigefläche. Besonders bevorzugt ist die Ausdehnung kleiner oder gleich der Wellenlänge des sichtbaren und/oder des durchzuleitenden Lichts. Sie beträgt z.B. höchstens 2 µm, bevorzugt höchstens 1 µm oder höchstens 0,5 µm. Hierdurch ist insbesondere aufgrund des Rayleigh-Kriteriums der Austrittswinkel des von der Leuchtfläche ausgehenden Lichts größer.

Der Anteil der nicht leuchtenden Flächen an der gesamten Anzeigefläche ist bevorzugt der Anteil der Summe aller Flächenanteile der nicht leuchtenden Flächen am Flächeninhalt der Gesamtanzeigefläche. Er ist bevorzugt invers zum Anteil der Leuchtflächen an der Anzeigefläche, d.h. der Anteil der nicht leuchtenden Flächen und der Anteil der leuchtenden Flächen an der gesamten Anzeigefläche ergibt bevorzugt 100%.

Der Anteil von Leuchtflächen an der Anzeigefläche ist bevorzugt der Anteil der Summe aller Flächenanteile der Leuchtflächen an der gesamten Anzeigefläche.

Die nicht leuchtenden Flächen der Anzeigefläche ergeben sich bisher üblicherweise aufgrund von Verdrahtungen der Ansteuerung von LCD-Zellen und man ist im Stand der Technik bestrebt, diese übrigen Flächen möglichst zu minimieren, damit die Leuchtflächen so viel Platz als möglich erhalten. Daher ist es bei einer bevorzugten Anzeigevorrichtung von Vorteil, wenn in den Raum zwischen den Leuchtflächen mindestens ein Funktionselement angeordnet ist, um den Platz zwischen den Leuchtflächen zu nutzen. Somit können mithilfe des mindestens einen Funktionselements weitere Funktionen integriert werden. So kann das mindestens eine Funktionselement beispielsweise ein Solarelement und/oder einen Sensor aufweisen. Bei einem solchen Sensor kann es sich beispielsweise um einen Temperatursensor, einen Abstandssensor, einen Drucksensor, einen Gassensor oder einen Bildsensor handeln.

Bevorzugt ist der Anteil der nicht leuchtenden Flächen an der gesamten Anzeigefläche größer als 80%, bevorzugt größer als 90%, besonders bevorzugt größer als 95%, ganz besonders bevorzugt größer als 98% und schließlich noch weiter bevorzugt mindestens 99%.

Bevorzugt ist analog dazu der Anteil der Leuchtflächen an der gesamten Anzeigefläche höchstens 20%, bevorzugt höchstens 10%, besonders bevorzugt höchstens 5%, ganz besonders bevorzugt höchstens 2% und schließlich noch weiter bevorzugt höchstens 1%. Je größer der Anteil der nicht leuchtenden Flächen und/oder je kleiner der Anteil der Leuchtflächen, desto stärker sind die eingangs erwähnten erfindungsgemäßen Effekte.

Die erfindungsgemäße Farbanzeigevorrichtung weist mindestens ein Funktionselement auf. Mithilfe des mindestens einen Funktionselements kann die Anzeigevorrichtung um weitere Funktionen erweitert werden. So kann das mindestens eine Funktionselement beispielsweise ein Solarelement zum Umwandeln von Sonnenenergie in elektrische Energie aufweisen. Dies erlaubt die Energieversorgung der Anzeigevorrichtung. Somit kann ein Teil oder die gesamte benötigte Energie für die Anzeigevorrichtung aus Sonnenenergie gewonnen werden, wodurch z. B. eine Batterie der Anzeigevorrichtung entlastet oder sogar eingespart werden kann.

Auch ist es möglich, dass das mindestens eine Funktionselement einen Sensor aufweist, vorzugsweise einen zweidimensionalen und/oder dreidimensionalen Sensor. Ferner ist es bevorzugt, wenn das mindestens eine Funktionselement einen Bildsensor oder einen berührungsempfindlichen Sensor aufweist, insbesondere ein Piezoelement. Ein Sensor kann dabei die Anzeigevorrichtung um eine weitere Anwendung erweitern, z. B. um die Detektion von Eingaben durch einen Benutzer. Benutzereingaben können beispielsweise mithilfe eines Temperatursensors, eines Abstandssensors, eines Drucksensors, eines Gassensors oder eines Bildsensors detektiert werden.

Dabei ist es vorteilhaft, wenn der Temperatursensor einen Wärmefühler mit Schwingquarz oder ein Thermoelement, das eine Temperaturdifferenz durch den Seebeck-Effekt in eine elektrische Spannung umwandelt, aufweist. Auch ist es möglich, dass der Temperatursensor ein pyroelektrisches Material aufweist, das die Ladungsträgerdichte an der Oberfläche bei Temperaturschwankungen durch Veränderung der spontanen Polarisation verändert, oder einen mechanisch arbeitenden Temperaturschalter, z. B. Bimetallschalter, der mithilfe von Verformung eines Bimetalls einen Schalter betätigt.

Ferner ist es von Vorteil, wenn der Abstandssensor nach dem Funktionsprinzip der variablen Kapazität arbeitet. Dabei weist ein kapazitiver Sensor zwei voneinander isolierte Plattenelemente auf, die einen Kondensator bilden, wobei z. B. der Finger eines Nutzer ein Dielektrikum darstellt. Das Dielektrikum im Kondensator variiert dessen Kapazität, welche durch Spannungsmessung leicht detektiert werden kann. Somit handelt es sich bei einem Abstandssensor um einen berührungsempfindlichen Sensor.

Auch ist es günstig, wenn der Drucksensor piezoresistiv oder piezoelektrisch ausgebildet ist. Bei einem piezoresistiven Drucksensor verformt der zu messende Druck eine Membran, welche über aufgebrachte elektrische Widerstände verfügt. Die druckabhängige Verformung der Membran verformt ebenfalls auf der Membran eindiffundierten Widerstände, wodurch es zur Ausbildung einer elektrischen Spannung kommt, welche ebenfalls auf einfache Weise gemessen werden kann. Bei einem piezoelektrischen Drucksensor verursacht der zu messende Druck eine Ladungstrennung in einem Kristall, wodurch eine elektrische Spannung erzeugt wird. Der Druck verschiebt im Inneren des Kristalls Ladungen, wodurch sich an der Oberfläche eine elektrische Ladung proportional zur Kraft bildet. Soll der Sensor für die Druckmessung eingesetzt werden, muss erst über eine Membran der Druck proportional in eine Kraft umgeformt werden. Folglich handelt es sich bei einem Drucksensor um einen berührungsempfindlichen Sensor, wobei der piezoresistive und der piezoelektrische Drucksensor ein Piezoelement aufweisen. Auch ist es denkbar, mithilfe des Drucksensors eine Kraft zu erzeugen und somit ein haptisches Feedback in Form einer Vibration zu gewährleisten, indem z. B. das Piezoelement des Drucksensors in Zyklen aktiviert und deaktiviert wird.

Günstigerweise ist der Sensor des mindestens einen Funktionselements ein Gassensor, welcher vorzugsweise nach einem resistiven Prinzip arbeitet, bei dem das zu messende Gas oder Gasgemisch direkt die Leitfähigkeit einer gasempfindlichen Sensorschicht beeinflusst. Diese Widerstandsänderung dient als Messgröße. Bei derartigen Sensoren handelt es sich um z. B. anorganische Metalloxid-Halbleiter (MOX) oder leitfähiges Polymer. Auch kann ein Gassensor nach dem kapazitiven Prinzip arbeiten, bei welchem die Kapazität eines Kondensators gemessen wird, die wiederum von einem gasempfindlichen Dielektrikum beeinflusst wird, wie beispielsweise bei einem Polymersensor zur Feuchtemessung.

Besonders bevorzugt weist das mindestens eine Funktionselement einen zweidimensionalen oder dreidimensionalen Sensor auf, insbesondere einen Bildsensor. Unter einem zweidimensionalen Sensor bzw. zweidimensionalen Bildsensor wird eine Vorrichtung zur Aufnahme von zweidimensionalen Abbildern verstanden, wofür halbleiterbasierte Bildsensoren verwendet werden, die Licht aufnehmen können. Dabei handelt es sich vorzugsweise um einen sog. CCD-Sensor oder einen sog. CMOS-Sensor. Ein dreidimensionaler Sensor bzw. dreidimensionaler Bildsensor weist zumindest zwei zueinander beabstandete zweidimensionale Sensoren bzw. Bildsensoren auf. Auf diese Weise kann ein Motiv nach dem Prinzip der Stereoskopie erfasst werden, um bei der Wiedergabe von zwei zweidimensional beabstandeten Abbildungen einen räumlichen Eindruck zu vermitteln.

Bei einer weiteren Anzeigevorrichtung weist das mindestens eine Funktionselement ein Strahlformelement und eine Strahldetektoreinrichtung auf. Günstigerweise lenkt das Strahlformelement, welches vorzugsweise lichtdurchlässig ist, Licht auf die Strahldetektoreinrichtung. Mithilfe dieser Ausgestaltung ist es beispielsweise möglich, eine plenoptische Kamera, auch Lichtfeldkamera genannt, oder eine Art Facettenauge wie bei einem Insekt zu realisieren. Hierzu ist es von Vorteil, wenn mehrere Funktionselemente eine solche Kamera bilden. Ferner ist es günstig, wenn das Strahlformelement in die Oberfläche der Anzeigevorrichtung eingepasst ist. Somit kann eine ebene Oberfläche realisiert werden. Bevorzugt ist das Strahlformelement eine Linse mit beliebiger Form und die Strahldetektoreinrichtung ein Bildsensor.

Eine plenoptische Kamera erfasst im Gegensatz zu einer herkömmlichen Kamera nicht nur die Position und Intensität eines Lichtstrahls, der auf einen Bildsensor trifft, sondern auch die Richtung, aus welcher der Lichtstrahl einfällt. Auf diese Weise kann eine sog. Lichtfeldmessung vorgenommen werden, welche z. B. in einem konkreten Anwendungsfall durch ein Gitter aus mehreren Mikrolinsen vor einem Bildsensor technisch realisierbar ist.

Vorteile einer plenoptischen Kamera sind eine hohe Schärfentiefe, kein Abwarten eines Fokussiervorgangs und eine nachträgliche Anpassung der Fokusebene eines aufgenommenen Bildes. Da sich aus den gewonnenen Bilddaten auch Tiefeninformationen ermitteln lassen, ist eine plenoptische Kamera auch als dreidimensionale Kamera geeignet, wobei mit den aufgenommenen Bilddaten auch eine nachträgliche Tiefenschärfenerweiterung möglich ist.

Des Weiteren ist es mittels des Funktionselements möglich, welches eine Strahlformelement und eine Strahldetektoreinrichtung aufweist, eine Fotokopie bzw. ein Bild z. B. eines Gegenstandes zu machen. Somit kann mit mehreren Funktionselementen ebenfalls eine gewöhnliche Kamera realisiert werden.

Ferner ist es von Vorteil, wenn eine Leuchtfläche und mindestens ein Funktionselement zeitgleich angesteuert werden, um mittels Reflexion und Absorption einen Gegenstand zu erfassen. Vorteilhafterweise grenzen die Leuchtfläche und das mindestens eine Funktionselement aneinander an. Somit kann einfach und effizient die Reflexion und Absorption eines Körpers bzw. Gegenstandes detektiert werden, wodurch eine Bestimmung der Oberfläche des Gegenstandes nach Eigenschaften wie z. B. Farbe, Helligkeit und Kontrast sowie Struktur möglich ist. Somit kann also ein Gegenstand erfasst bzw. gescannt bzw. kopiert werden, sodass eine Kopie dessen darstellbar ist, insbesondere über die Anzeigevorrichtung bzw. deren Leuchtflächen und nicht leuchtenden Flächen. Dabei ist es günstig, wenn der Gegenstand nah an, insbesondere direkt an, der Anzeigevorrichtung angeordnet ist. Denn je näher der Gegenstand desto besser und realistischer kann die Anzeigevorrichtung mithilfe der Leuchtflächen sowie mithilfe des mindestens einen Funktionselements diesen Gegenstand erfassen.

Bei einer Kamera nach Art eines Facettenauges eines Insekts kann die zeitliche Auflösung gegenüber einer Standard-Kamera höher sein. Diese hohe zeitliche Auflösung eignet sich insbesondere für bewegte Objekte, wie z. B. Finger. Somit kann mithilfe einer Kamera nach Art eines Facettenauges ein dreidimensionaler Sensor z. B. zur Eingabe von Nutzerbefehlen realisiert werden. Für eine konkrete Umsetzung eines vorgenannten Facettenauges kann das beschriebene mindestens eine Funktionselement genutzt werden, insbesondere in Zusammenschaltung mit weiteren Funktionselementen, wobei jedes Funktionselement vorzugsweise ein Strahlformelement und eine Strahldetektoreinrichtung aufweist. Günstigerweise ist im Gegensatz zu einem realen Facettenauge das durch die Anzeigevorrichtung künstlich nachgebildete Auge eben ausgebildet, bevorzugterweise in der Ebene der Anzeigevorrichtung.

Zusammengefasst können mithilfe des mindestens einen Funktionselements in Umsetzung als Sensor mit einer Vielzahl von Kameras dreidimensionale Touch- und Näherungssensoren realisiert werden.

Ferner ist es günstig, wenn das mindestens eine Funktionselement einen optoelektronischen Sensor aufweist. Dabei ist es bevorzugt, wenn das mindestens eine Funktionselement einen optoelektronischen Sensor mit Sender und Empfänger aufweist. Auf diese Weise können Objekte bzw. Gegenstände hinsichtlich ihrer Form von der Anzeigevorrichtung detektiert werden. Durch Anordnung mehrerer solcher optoelektronischer Sensoren nebeneinander kann ein Detektionsfeld für Gegenstände umgesetzt werden, die vor der Anzeigevorrichtung positioniert werden. Somit können ebenfalls Finger eines Nutzers detektiert werden, wodurch Nutzereingaben erfassbar werden. Selbstverständlich können - wie bereits erwähnt - auch Oberflächen von Gegenständen sowie deren Form erfasst werden.

Bei einer weiteren erfindungsgemäßen Anzeigevorrichtung weist zumindest eine nicht leuchtende Fläche mindestens ein Funktionselement auf. Somit kann der Raum zwischen zwei Leuchtflächen für das mindestens eine Funktionselement genutzt werden. Eine derartige Anordnung erlaubt es z. B. einen Temperatursensor, Abstandssensor, Drucksensor, Gassensor oder Bildsensor zusätzlich in die Anzeigevorrichtung zu integrieren, wodurch der zur Verfügung stehende Bauraum bestmöglich genutzt wird. Somit können kleine Geräte mit einer hohen Sensordichte und weiteren Eigenschaften geschaffen werden.

Bei einer weiteren Anzeigevorrichtung sind eine oder mehrere Leuchtflächen einem Pixel zugeordnet und die Anzeigefläche weist eine Vielzahl solcher Pixel auf, die in einem sich, bevorzugt gleichmäßig, wiederholenden Muster angeordnet sind, so dass aus den Pixeln Bilder zusammengesetzt werden können.

Bevorzugt weisen Leuchtflächen eines Pixels geringere gegenseitige Abstände auf als die Abstände zu Leuchtflächen eines anderen Pixels. Bevorzugt ist eine Leuchtfläche, besonders bevorzugt sind alle Leuchtflächen von anderen Leuchtflächen anderer Pixel getrennt, z.B. durch einen Bereich, der nicht leuchtfähig oder lichtleitfähig ist, d.h. durch nicht leuchtenden Flächen. Z.B. ist die Anzeigevorrichtung monochrom und die Pixel sind jeweils durch eine einzelne Leuchtfläche gebildet, oder die Anzeigevorrichtung ist polychrom und die Pixel sind jeweils durch zwei oder mehr Leuchtflächen gebildet, wobei die Leuchtflächen in unterschiedlichen Primärfarben leuchten oder die Pixel sind durch je eine Leuchtfläche gebildete, die polychrom leuchtet.

Bei einer weiteren erfindungsgemäßen Anzeigevorrichtung weist eine Mehrheit, bevorzugt alle, der nicht leuchtenden Flächen einen Reflexionsgrad diffuser Reflexion von weniger als 50 % auf.

Hierdurch werden die nicht leuchtenden Flächen vorteilhaft dazu genutzt, das Kontrastverhältnis positiv zu beeinflussen. Je weniger diffuse Reflexion auftritt, desto dunkler erscheinen die nicht leuchtenden Flächen. Ein entscheidender Vorteil dabei ist wiederum, dass man im Gegensatz zu üblichen Anzeigevorrichtungen eine viel größere Fläche zur Verfügung stehen hat (nämlich die gesamte Fläche aller nicht leuchtenden Flächen), um einen niedrigen Reflexionsgrad zu erzeugen, wobei dabei nicht darauf geachtet werden muss, dass die nicht leuchtenden Flächen transparent sein müssen oder Licht weiterleiten können, und somit einfacher und mit größerem Spielraum ein niedriger Reflexionsgrad erreicht werden kann (z.B. mittels Materialwahl, Oberflächenstruktur, Oberflächenbeschichtung etc.). Bevorzugt ist der Reflexionsgrad diffuser Reflexion weniger als 25 %, besonders bevorzugt weniger als 10 %, ganz besonders bevorzugt weniger als 5 % und noch weiter bevorzugt weniger als 1 %.

Im Gegensatz dazu, wird im Stand der Technik der Hintergrund der leuchtenden Flächen (OLED, LCD, LED, etc.) mit sehr hohem Reflexionsgrad versehen, um so viel Licht wie möglich (mittels einer leuchtenden Fläche so groß wie möglich) nach vorne zu bringen. Das wirkt sich auf den Kontrast in dunkleren Bereichen negativ aus, insbesondere bei starkem Umgebungslicht, was wiederum zwingt die Lichtintensität zu erhöhen, um einen guten Kontrast gegenüber dem Umgebungslicht zu erzielen, was wiederrum mehr Energie kostet. Das ist wiederrum ein wesentlicher Nachteil für z.B. tragbare Geräte. Mit dieser Erfindung wird genau das Gegenteil angestrebt und erreicht (auch wenn der Hintergrund der minimalen leuchtenden Flächen mit einem sehr hohen Reflexionsgrad versehen sind).

Ein Reflexionsgrad diffuser Reflexion ist bevorzugt als sog. Light Reflectance Value, LVR (bevorzugt gemäß dem britischen Messstandard BS8493:2008+A 1 :201 0), besonders bevorzugt als Albedowert mittels eines Albedometers messbar, wobei bevorzugt eine Mehrheit, bevorzugt alle der nicht leuchtenden Flächen einen Albedo von weniger als 0,5, bevorzugt weniger als 0,25, besonders bevorzugt weniger als 0,10, ganz besonders bevorzugt weniger als 0,05 und noch weiter bevorzugt weniger als 0,01 aufweisen. Albedo ist dabei bevorzugt das Verhältnis des von einer vollen bestrahlten Fläche zum Beobachter gelangenden Strahlungsstroms zu dem, der von einer diffus reflektierenden, absolut wei-ßen Scheibe (ein sogenannter Lambertstrahler) gleicher Größe bei senkrechtem Lichteinfall zum Beobachter gelangen würde.

Bei einer weiteren erfindungsgemäßen Anzeigevorrichtung weist eine Mehrheit, bevorzugt alle, der nicht leuchtenden Flächen einen Reflexionsgrad spiegelnder Reflexion von weniger als 50 % auf.

Hierdurch werden die nicht leuchtenden Flächen vorteilhaft dazu genutzt, das Kontrastverhältnis positiv zu beeinflussen. Je weniger spiegelnde Reflexion auftritt, desto dunkler erscheinen die nicht leuchtenden Flächen, da sich hellere Objekte weniger an ihnen spiegeln. Zudem wird die Lesbarkeit erhöht, da ein Überblenden von ungleichmäßigen Spiegelbildern über das Anzeigebild reduziert wird. Ein entscheidender Vorteil dabei ist wiederum, dass man im Gegensatz zu üblichen Anzeigevorrichtungen eine viel größere Fläche zur Verfügung stehen hat, um einen niedrigen Reflexionsgrad zu erzeugen. Bevorzugt ist der Reflexionsgrad spiegelnder Reflexion weniger als 25 %, besonders bevorzugt weniger als 10 %, ganz besonders bevorzugt weniger als 5 % und noch weiter bevorzugt weniger als 1 %. Im Stand der Technik (herkömmliche Bildschirme) werden die (größeren) Leuchtenden Flächen meist mit Glas oder glasähnlichem Material versehen, und somit weist die gesamte Anzeigefläche einen größeren spiegelnden Reflexionsgrad auf. Im Gegensatz dazu basiert diese Erfindung auf sehr kleinen Leuchtflächen, so dass die Anzeigefläche deshalb kaum spiegelnde Reflexionen aufweist, auch wenn die Leuchtflächen mit Glas oder glasähnlichem Material versehen sind.

Ein Reflexionsgrad spiegelnder Reflexion ist bevorzugt in GU (gloss unit) mittels eines Glanzmessgeräts messbar, wobei bevorzugt eine Mehrheit, bevorzugt alle der nicht leuchtenden Flächen einen Glanz in GU von weniger als 50 GU, bevorzugt weniger als 25 GU, besonders bevorzugt weniger als 10 GU, ganz besonders bevorzugt weniger als 5 GU und noch weiter bevorzugt weniger als 1 GU aufweisen. Bevorzugt basiert die Skala für GU auf dem Referenzwert, der bei einem polierten, schwarzen Glas erreicht wird. Bei einer Kalibrierung wird dieser Referenzwert bevorzugt als 100 GU festgesetzt. Der zweite Referenzpunkt der Skala liegt bevorzugt bei 0 GU, dem Messwert, der bei einer perfekt matten Oberfläche erreicht wird.

Bei einer weiteren erfindungsgemäßen Anzeigevorrichtung weist die gesamte Anzeigefläche einen Reflexionsgrad diffuser Reflexion von weniger als 50 % und/oder einen Reflexionsgrad spiegelnder Reflexion von weniger als 50 % auf.

Dadurch, dass der Anteil der nicht leuchtenden Flächen an der Gesamtfläche dominiert, kann in einfacher Weise auch ein Reflexionsgrad (spiegelnd und/oder diffus) der gesamten Anzeigefläche effektiv reduziert werden und somit ein sehr gutes Kontrastverhältnis erhalten werden. Bevorzugt ist der Reflexionsgrad spiegelnder Reflexion der gesamten Anzeigefläche weniger als 25 %, besonders bevorzugt weniger als 10 %, ganz besonders bevorzugt weniger als 5 % und noch weiter bevorzugt weniger als 1 %. Bevorzugt ist der Reflexionsgrad diffuser Reflexion der gesamten Anzeigefläche weniger als 25 %, besonders bevorzugt weniger als 10 %, ganz besonders bevorzugt weniger als 5 % und noch weiter bevorzugt weniger als 1 %.

Bei einer weiteren erfindungsgemäßen Anzeigevorrichtung weist eine Mehrheit, bevorzugt alle, der nicht leuchtenden Flächen eine dunkle Farbe auf oder ist schwarz.

Hierdurch wird ein niedriger Reflexionsgrad insbesondere der diffusen Reflexion erreicht.

Eine dunkle Farbe ist bevorzugt eine Farbe in einem RGB-Farbraum (z.B. sRGB oder Adobe RGB 1998), deren Mittelwert aus R-Wert, G-Wert und B-Wert kleiner oder gleich als 25% des Maximalwerts ist, d.h. z.B. bei einem Maximalwert von 255 (je R,G,B 256 Stufen) ist der Mittelwert kleiner als 63,75 ist.

Besonders bevorzugt ist eine dunkle Farbe eine der Pantonefarben: 1545, 1545 C, 161, 161 C, 168, 1815, 1817, 2617 C, 262, 2627, 2627 C, 2685 C, 2695 C, 273 C, 2735 C, 2738, 2738 C, 274, 274 C, 2745, 2745 C, 2747, 2747 C, 2748, 2748 C, 275, 275 C, 2755, 2755 C, 2756 C, 2757, 2757 C, 2758, 2758 C, 276, 276 C, 2765, 2765 C, 2766, 2766 C, 2767, 2767 C, 2768, 2768 C, 280, 280 C, 281, 281 C, 282, 282 C, 287 C, 288, 288 C, 289, 289 C, 294 C, 295, 295 C, 2955, 2955 C, 296, 296 C, 2965, 2965 C, 302, 302 C, 3025, 303, 303 C, 3035, 3035 C, 309, 309 C, 316, 316 C, 3165, 3165 C, 3292, 3292 C, 3298 C, 330, 330 C, 3302, 3302 C, 3305, 3305 C, 3308, 3308 C, 336, 336 C, 342, 342 C, 3425, 3425 C, 343, 343 C, 3435, 3435 C, 349, 349 C, 350, 350 C, 356, 356 C, 357, 357 C, 368 2X, 412, 412 C, 419, 419 C, 426, 426 C, 432 C, 433, 433 2X, 433 C, 439, 439 C, 440, 440 C, 447, 447 C, 448 C, 4485, 4625, 4625 C, 469, 4695, 4695 C, 476 C, 483, 483 C, 490, 490 C, 497, 497 C, 4975, 4975 C, 504, 504 C, 505, 5115, 5115 C, 5185, 5185 C, 5255, 5255 C, 532, 532 C, 533 C, 534 C, 539, 539 C, 5395, 5395 C, 540, 540 C, 541, 541 C, 546, 546 C, 5463, 5463 C, 5467, 5467 C, 547, 547 C, 548, 548 C, 553, 553 C, 5535, 5535 C, 554, 554 C, 560, 560 C, 5605, 5605 C, 561 C, 567 C, 5743 C, 5747 C, 5753, 5757, 5815, 626, 627, 627 C, 648, 648 C, 654, 654 C, 655, 655 C, 662, 662 C, 669 C, 725, 731, 732, 732 C, 7421 C, 7449 C, 7463 C, 7476 C, 7483 C, 7484 C, 7533 C, 7546 C, 7547 C, 7554 C, 7631 C, 7645 C, 7693 C, 7694 C, 7720 C, 7721 C, 7722 C, 7727 C, 7728 C, 7729 C, 7732 C, 7733 C, Black, Black 2, Black 2 2X, Black 2 C, Black 3, Black 3 2X, Black 3 C, Black 4, Black 4 2X, Black 4 C, Black 5, Black 5 2X, Black 5 C, Black 6, Black 6 2X, Black 6 C, Black 7, Black 7 2X, Black 7 C, Black C, Blue 072 C, Dark Blue C, Neutral Black C, Reflex Blue, Reflex Blue 2X, Reflex Blue C.

Bei einer weiteren erfindungsgemäßen Anzeigevorrichtung weist eine Mehrheit, bevorzugt alle, der nicht leuchtenden Flächen einen Mittenrauwert im Bereich von 0,2 µm und 1,0 µm auf.

Hierdurch werden insbesondere spiegelnde Reflexionen im Bereich der Wellenlängen des sichtbaren Lichts reduziert. Bevorzugt liegt der Mittenrauwert im Bereich von 0,4 µm - 0,8 µm. Bevorzugt wird zur Ermittlung dieses Messwertes die Oberfläche auf einer definierten Messstrecke abgetastet und sämtliche Höhen- und Tiefenunterschiede der rauen Oberfläche werden aufgezeichnet. Nach der Berechnung des bestimmten Integrals dieses Rauheitsverlaufes auf der Messstrecke wird abschließend dieses Ergebnis durch die Länge der Messstrecke dividiert.

Bei einer weiteren erfindungsgemäßen Anzeigevorrichtung sind eine Mehrheit, bevorzugt alle, der nicht leuchtenden Flächen mittels einer Antireflexbeschichtung beschichtet.

Hierdurch werden ebenfalls insbesondere spiegelnde Reflexionen reduziert. Eine Antireflexbeschichtung ist bevorzugt eine Entspiegelungsfolie (z.B. 3M^{™} Vikuiti^{™}) oder eine Entspiegelungsbeschichtung. Die Antireflexbeschichtung weist bevorzugt eine raue Oberfläche auf (z.B. mit Mittenrauwert im Bereich von 0,2 µm bis 1,0 µm) und/oder Entspiegelungsschichten basierend auf destruktiver Interferenz auf.

Bei einer weiteren erfindungsgemäßen Anzeigevorrichtung weist die Anzeigevorrichtung eine elektronische Kompensationseinrichtung auf, mittels welcher eine minimale Helligkeit der Leuchtflächen für die Anpassung der Darstellung schwarzer Bildpixel in Abhängigkeit der Umgebungshelligkeit automatisch einstellbar ist.

Hierdurch ist das Kontrastverhältnis an die Umgebungshelligkeit anpassbar. Auch wenn die nicht leuchtenden Flächen möglichst dunkel und nicht reflektierend ausgestaltet sind, wird die Helligkeit der nicht leuchtenden Flächen je nach Umgebungshelligkeit heller oder dunkler sein. Mittels der Kompensationseinrichtung kann die minimale Helligkeit der Leuchtflächen nun jedoch auch entsprechend an die Helligkeit der nicht leuchtenden Flächen angepasst werden. Ein schwarzer Bildpixel ist ein solcher, der z.B. als RBG Bildinformation (0, 0, 0) enthält. Mittels der Kompensationseinrichtung wird dieser Schwarzpunkt an die Umgebungshelligkeit angepasst, d.h. z.B. wird er bei größerer Umgebungshelligkeit erhöht und bei niedrigerer Umgebungshelligkeit reduziert. Z.B. wird bei hoher Sonneneinstrahlung ein schwarzer Bildpunkt nicht durch komplett ausgeschaltete Leuchtflächen dargestellt, sondern die Leuchtflächen werden mit einer Helligkeit angesteuert, so dass die Leuchtflächen in etwa dieselbe Helligkeit wie die nicht leuchtenden Flächen aufweisen. Die übrigen Helligkeitsstufen des anzuzeigenden Bilds werden dann auf den verbleibenden Bereich zwischen der durch die Kompensationseinrichtung eingestellten minimalen Helligkeit und der maximalen Helligkeit der Leuchtflächen verteilt. Auf diese Weise "versinkt" der dunkle Bildanteil nicht. Bevorzugt weist die elektronische Kompensationseinrichtung einen Umgebungslichtsensor auf.

Im weiteren Verlauf der Beschreibung werden unter anderem auch Lichtquellen genannt. Diese und deren Zusammenhang mit den Leuchtflächen werden vorgreiflich global beschrieben.

Eine Lichtquelle ist bevorzugt eine steuerbare, Lichtquelle, wobei das von der Lichtquelle ausgesendete Licht zumindest an- und ausschaltbar ist, bevorzugt ist jedoch die Intensität des ausgesendeten Lichts in mehreren Stufen oder kontinuierlich modulierbar. Sie ist z.B. eine aktive Lichtquelle wie eine LED (OLED, Mikro-LED), ein Laser (z.B. ein VCSEL bzw. Oberflächenemitter), bevorzugt mit einem Strahldurchmesser von 5 µm oder weniger, oder eine Plasmazelle. Damit sind sehr kleine und energieeffiziente Lichtquellen möglich. Eine Lichtquelle kann auch eine UV-LED oder blaue LED, die mit einer Leuchtstoffschicht zusammenwirkt, oder ein Elektronen-Emitter, der mit einer Leuchtsotffschicht zusammenwirkt, sein. Die maximale Ausdehnung einer leuchtaktiven Fläche (d.h. aktive Leuchtfläche) der Lichtquelle (z.B. die Fläche des pn-Übergangs) oder eines von der Lichtquelle erzeugten Laserstrahls parallel zur Anzeigefläche ist bevorzugt kleiner oder gleich der maximalen Ausdehnung der Leuchtfläche, d.h. z.B. höchstens 70 µm, bevorzugt höchstens 25 µm, besonders bevorzugt höchstens 10 µm oder 5 µm oder noch geringer z.B. 2 µm, 1 µm oder 0,5 µm. Bevorzugt weist die Leuchtfläche ein Streuelement auf, insbesondere dann, wenn die maximale Ausdehnung des von der Lichtquelle erzeugten Strahls, insbesondere Laserstrahls, kleiner als die maximale Ausdehnung der Leuchtfläche ist. Bevorzugt sind die Lichtquellen Elemente eines Lichtquellenarrays oder Pixel oder Subpixel eines als Beleuchtungseinrichtung in die Anzeigevorrichtung integrierten und hinter den Beleuchtungsflächen angeordneten Displays, insbesondere OLED-Displays. Z.B. ist einer Leuchtfläche ein Pixel- und/oder Subpixel-Array eines Displays zugeordnet, z.B. 1x2, 2x2, 4x4, 5x5, 10x10 oder 100x100 Pixel oder Subpixel.

Vorzugsweise weist eine Lichtquelle, insbesondere ausgestaltet als UV-LED oder blaue LED, eine Schicht mit Quantenpunkten oder Phosphor auf, um einen RGB-Farbraum (z.B. sRGB oder Adobe RGB 1998) oder einen höher abgestimmten Farb-Bereich bzw. Farbraum zu generieren. Bei einem Quantenpunkt handelt es sich um eine nanoskopische Materialstruktur, welche in der Regel Halbleitermaterial (z. B. InGaAs, CdSe oder auch GalnP/lnP) aufweist, bei welchem Ladungsträger, eben in einem Quantenpunkt, in ihrer Beweglichkeit in allen Raumrichtungen eingeschränkt sind. Auf diese Weise kann ihre Energie nicht mehr kontinuierliche, sondern nur noch diskrete Werte annehmen. Somit ist es möglich, elektronische und optische Eigenschaften von Quantenpunkten exakt auf gewünschte Aufgabenstellungen anzupassen.

Günstigerweise weist ein Pixel drei Quantenpunkte auf, mit welchen gewünschte optische Eigenschaften in den drei Raumrichtungen gezielt einstellbar sind. Vorteilhafterweise kann die Schicht mit Quantenpunkten oder Phosphor in einem Druckverfahren, insbesondere in einem dreidimensionalen Druckverfahren, aufgedruckt werden und auch als Diffusionsschicht bzw. lichtstreuende Schicht dienen.

Ferner ist es mittels der Schicht mit Quantenpunkten möglich, durch eine Leuchtfläche in einer Richtung gezielt Licht auszusenden und Licht aus einer anderen Richtung aufzunehmen. Somit kann eine Leuchtfläche und ein Funktionselement in einem realisiert werden.

Bevorzugt ist mindestens eine der Lichtquellen, bevorzugt jede Lichtquelle, eine dichromatische, bevorzugt polychromatische Lichtquelle oder es sind unterschiedliche Lichtquellen mit verschiedenen Emissionswellenlängen vorhanden. Hierdurch ist eine zwei- oder mehr- bzw. vollfarbige Darstellung mittels der Anzeigevorrichtung möglich. Monochromatisch bedeutet bevorzugt, dass die Lichtquelle im wesentlichen in einem bestimmten, bevorzugt gleichbleibendem Wellenlängenbereich oder Wellenlängenmix Licht emittiert (z.B. Rot), dichromatisch bedeutet bevorzugt, dass die Lichtquelle eingerichtet ist, steuerbar in zwei verschiedenen Wellenlängenbereichen Licht zu emittieren (z.B. ein jeweils steuerbarer Grün- und Rot-Anteil), polychromatisch bedeutet bevorzugt dass die Lichtquelle eingerichtet ist, steuerbar in zwei oder mehr verschiedenen Wellenlängenbereichen Licht zu emittieren (z.B. ein jeweils steuerbarer Grün- und Rotund Blau-Anteil).

Bevorzugt ist jeder Leuchtfläche genau eine polychromatische Lichtquelle zugeordnet. Hierdurch ist eine Zuordnung der Lichtquellen zu den Leuchtflächen gegeben, wodurch eine Einzelmodulation der Lichtquellen möglich ist und somit unterscheidet sich diese Ausführungsform z.B. von einem im Energieverbrauch schlechteren LCD, bei dem großflächig Licht erzeugt wird, und dann jedoch lokal wieder abdunkelt werden muss. Anstatt dieses räumlich subtraktiven Bildaufbaus wird bevorzugt ein räumlich additiver Bildaufbau ermöglicht. Unterschiedlich monochromatische Lichtquellen sind z.B. solche, die jeweils für sich in einem Wellenbereich abstrahlen, die Wellenlängenbereiche der einzelnen Lichtquellen unterscheiden sich jedoch (z.B. Rot, Grün, Blau). Gleich monochromatische Lichtquellen sind z.B. solche, die alle jeweils im wesentlich gleichen Wellenbereich abstrahlen. Alternativ sind mehrere Leuchtflächen einer oder mehreren monochromatischen Lichtquellen, bevorzugt polychromatischen Lichtquellen zugeordnet. Bevorzugt ist dabei ein Pixel durch mehrere Leuchtflächen gebildet, denen Lichtquellen unterschiedlicher Wellenlängen zugeordnet sind. Z.B. ist ein Pixel durch drei oder mehr Leuchtflächen gebildet, wobei zumindest einer Leuchtfläche eine oder mehrere Lichtquellen zugeordnet sind, die grünes Licht zur Leuchtfläche ausstrahlen, zumindest einer zweiten Leuchtfläche eine oder mehrere Lichtquellen zugeordnet sind, die blaues Licht zur zweiten Leuchtfläche ausstrahlen, und zumindest einer dritten Leuchtfläche eine oder mehrere Lichtquellen zugeordnet sind, die rotes Licht zur dritten Leuchtfläche ausstrahlen. Bevorzugt existiert je ein Lichtpfad zu je einer der Leuchtflächen für mehrere monochromatische Lichtquellen. Alternativ existiert je ein Lichtpfad zu je einer der Leuchtflächen für eine oder mehrere polychromatische Lichtquellen. Bevorzugt ist dabei ein nicht-abbildendes optisches Element, z.B. ein Streuelement, für eine vorteilhafte Homogenisierung der polychromatischen Lichtquellen vorhanden.

Erfindungsgemäß weist die Anzeigevorrichtung eine Beleuchtungseinrichtung mit einem Substrat auf, auf dem mindestens eine Lichtquelle bzw. mehrere Lichtquellen angeordnet sind. Hierdurch ist in einfacher Weise eine Anzeigevorrichtung mit einer erfindungsgemäßen Anzeigefläche realisierbar.

Ferner sind auf dem Substrat mindestens eine Lichtquelle und mindestens ein Funktionselement angeordnet. Dies erlaubt einen einfachen Aufbau und somit eine kostensparende Herstellung, da sowohl die Lichtquelle als auch das mindestens eine Funktionselement sich Schritte bei der Herstellung teilen. Auch erleichtert eine Anordnung von verschiedenen Bauteilen auf einem Substrat bzw. auf einer Grundebene die Prüfung auf Herstellungsfehler. Besonders einfach ist der Aufbau, wenn die mindestens eine Lichtquelle und das mindestens eine Funktionselement unmittelbar auf dem Substrat angeordnet sind. Somit ist zumindest teilweise eine Herstellung von Lichtquelle, Funktionselement und Substrat in einem Arbeitsgang möglich. Somit können Produktionszeit und Kosten gespart werden.

Die Beleuchtungseinrichtung ist bevorzugt von dem Betrachter aus hinter den Leuchtflächen angeordnet und eingerichtet, die Leuchtflächen von hinten zu beleuchten, das heißt von deren Rückseite. Die Rückseite ist die dem Betrachter abgewandte Seite einer Leuchtfläche. Dabei ist es bevorzugt, wenn die Leuchtflächen als eine Fläche verstanden werden, von welcher aus in einem eingeschaltetem Modus Lichtstrahlen zu dem Betrachter ausgehen. Wie bereits erwähnt erstreckt sich die Fläche bevorzugt teilweise oder ganz durch Luft bzw. einen körperlosen Bereich. Dabei ist sie bevorzugt durch einen Rahmen oder eine Maske umrahmt. Vereinfacht dargestellt, kann eine Leuchtfläche also ein Loch bzw. eine Bohrung sein, welche Licht bzw. Lichtstrahlen eine Öffnung bieten, von welcher aus die Lichtstrahlen zu dem Betrachter gelangen.

Die Beleuchtungseinrichtung weist bevorzugt eine oder mehrere aktive Lichtquellen auf oder passive Lichtquellen, wie z.B. Umlenkspiegel, welche Licht von einer anderen Lichtquelle, was zum Beispiel auch Umgebungslicht, insbesondere Tages- bzw. Sonnenlicht darstellen kann, auf die Leuchtflächen von hinten leiten.

Der Abstand zwischen den Leuchtflächen und der Beleuchtungseinrichtung (z.B. gemessen ab einer lichtemittierenden oder -reflektierenden Fläche der Beleuchtungseinrichtung, welche Licht bereits im Wesentlichen parallel zur Betrachtungsrichtung aussendet oder weiterleitet) beträgt bevorzugt höchstens 3 mm, besonders bevorzugt höchstens 1 mm, ganz besonders bevorzugt höchstens 0,5 mm oder noch bevorzugter höchstens 0,2 mm.

Das Substrat ist bevorzugt eine ebene Platte, z.B. eine Platine oder ein Waver.

Eine mögliche Realisierung von Lichtquellen sieht zum Beispiel Laser mit z.B. 5 µm Strahldurchmesser vor, die auf einem Substrat (wie zum Beispiel einem Si-Waver) als Array angeordnet sind, z.B. in Form eines Quadrats mit z.B. 50 µm Kantenlänge. Bevorzugt ist über einem solchen Quadrat ein Streuelement angeordnet, welches auch gleichzeitig die Leuchtfläche bildet. Die einzelnen Laser in einem Quadrat weisen bevorzugt voneinander verschiedene Emissionswellenlängen auf. Viele solche Einheiten bilden dann Pixel oder Subpixel der Anzeigevorrichtung.

Bei einer weiteren erfindungsgemäßen Anzeigevorrichtung ist mindestens ein Funktionselement zwischen zwei Leuchtflächen und/oder zwischen zwei Lichtquellen angeordnet. Auf diese Weise kann der ungenutzte Raum zwischen den Lichtquellen bzw. den Leuchtflächen für weitere Funktionen genutzt werden, wie z.B. Sensoren in konkreter Ausgestaltung des mindestens einen Funktionselements.

Auch ist es möglich, dass mindestens ein Funktionselement zwischen einer nicht leuchtenden Fläche und einer Lichtquelle angeordnet ist. Auch bei einer Ausgestaltung der Anzeigevorrichtung mit minimalem Abstand zwischen einer nicht leuchtenden Fläche und einer Lichtquelle bzw. einer Leuchtfläche kann der sich ergebende Raum genutzt werden, um weitere Funktionalitäten durch z. B. ein Solarelement zur Energiegewinnung oder einen Sensor, insbesondere einen Berührungssensor, zu integrieren. Somit kann eine platzsparende Konstruktion realisiert werden.

Bei einer weiteren erfindungsgemäßen Anzeigevorrichtung sind die Leuchtflächen jeweils durch eine der Lichtquellen oder durch ein von einer der Lichtquellen beleuchtbares optisches Streuelement oder transparentes Abdeckelement oder optisches Farbfilterelement gebildet und die nicht leuchtenden Flächen der Anzeigefläche sind durch Flächen des Substrats und/oder durch Flächen eines Füllmaterials zwischen den Leuchtflächen gebildet.

Durch diese bevorzugte Ausgestaltung der Leuchtflächen und Zuordnung zu den Lichtquellen ist eine besonders effiziente Bilddarstellung möglich. Durch die Ausgestaltung der nicht leuchten Flächen aus Substratmaterial oder Füllmaterial sind insbesondere die reflektierenden Eigenschaften der nicht leuchtenden Flächen sehr gut einstellbar. Das Füllmaterial ist bevorzugt ein gießbares Material oder es ist mittels eines 3D-Druckverfahrens zwischen den Lichtquellen aufgebaut oder ein in der Form her anpassbare Material (rund um die leuchtenden Flächen) oder ein Material, das die leuchtenden Flächen durchscheinen lässt (transparent und/oder engmaschig und/oder gelöchert).

Ein optisches Streuelement ist bevorzugt ein Körper, welcher Licht, welches aus einer Richtung auf das Streuelement auftrifft, in mehr als zwei verschiedene, bevorzugt in eine Vielzahl verschiedener Richtung weiterleitet, sei es transmissiv und/oder reflektiv. Z.B ist das optische Streuelement ein semi-transparenter und/oder matter Körper (Milchglaskörper) aus Glas oder Plastik, bevorzugt mit eingelassenen Streupartikeln (z.B. Silberpartikel oder Nanopartikel), ein Mikroprisma, Mattfilm zum Aufkleben, eine winzige Mattscheibe oder eine diffraktive Optik, z.B. ein Gitter. Das Streuelement ist bevorzugt eingerichtet, (annähernd) als Lambertstrahler zu dienen, z.B. so dass eine gleichmäßig Abstrahlung innerhalb eines großen Raumwinkels, z.B. 180°, erfolgt. Bevorzugt ist es eingerichtet gemäß dem Rayleigh-Effekt zu streuen und/oder gemäß dem Plasmonic-Effekt. Z.B bedeutet das, dass das Streuelement Öffnungen aufweist, welche kleiner als die Wellenlänge des sichtbaren und/oder durchzuleitenden Lichts sind (z.B. 1 µm oder kleiner). Bevorzugt ist, z.B. in diesem Fall, die Leuchtfläche durch eine nicht-transparente Maske (z.B. eine später noch beschriebene Abdeckschicht) oder einen Rahmen umrahmt, und die Ausdehung der Leuchtfläche ist z.B. kleiner, als die Wellenlänge des sichtbaren und/oder des durchzuleitenden Lichts, so dass allein durch die Größe der Leuchtfläche in Kombination einer Umrahmung ein Streuelement geben ist.

Bei einer weiteren erfindungsgemäßen Anzeigevorrichtung sind die Leuchtflächen jeweils durch ein Loch bzw. eine Bohrung oder eine der Lichtquellen oder durch einen geformten Körper gebildet, wobei vorzugsweise die nicht leuchtenden Flächen der Anzeigefläche durch Flächen des Substrats und/oder durch Flächen eines Füllmaterials zwischen den Leuchtflächen gebildet sind.

Wie bereits eingangs erläutert, wird unter einer Leuchtfläche eine Fläche verstanden, von welcher aus in einem eingeschaltetem Modus Lichtstrahlen zu dem Betrachter ausgehen. Die Lichtstrahlen können entweder direkt in der Fläche generiert bzw. ausgesendet werden (z.B. durch eine in der Leuchtfläche angeordnete aktive Lichtquelle wie einer LED) oder sie können durch die Leuchtfläche zu dem Betrachter weitergeleitet werden (Hintergrundbeleuchtung wie bei LCD Bildschirmen). Die Fläche erststreckt sich bevorzugt teilweise oder ganz durch Luft bzw. einen körperlosen Bereich. Dabei ist sie bevorzugt durch einen Rahmen oder eine Maske umrahmt. Vereinfacht dargestellt, kann eine Leuchtfläche also ein Loch bzw. eine Bohrung sein, welche Licht bzw. Lichtstrahlen eine Öffnung bieten, von welcher aus die Lichtstrahlen zu dem Betrachter gelangen.

Besonders bevorzugt ist, dass der geformte Körper oder die Leuchtfläche, insbesondere ausgestaltet als Loch bzw. Bohrung, eine Parallaxbarriere bildet, die vorzugsweise als Streifenmaske oder Linse ausgestaltet ist, welche durch Ablenkung bzw. Brechung des hindurchgehenden Lichts z. B. eines Pixels eine optische Abbildung vermittelt. Anders ausgedrückt ist es von Vorteil, wenn die Leuchtflächen einen geformten Körper aufweisen, insbesondere eine Parallaxbarriere, ausgebildet als Streifenmaske oder Linse, um durch Ablenkung bzw. Brechung des hindurchgehenden Lichts eine optische Abbildung zu vermitteln.

Ferner ist es bei der Ausgestaltung der Leuchtflächen als Loch bzw. Bohrung bevorzugt, Lichtquellen, ausgestaltet als Pixel, in einem Abstand zu den Leuchtflächen zu positionieren. Der Abstand liegt bevorzugt zwischen 200 und 300 µm, besonders bevorzugt bei 200, 250 oder 300 µm. Damit ist eine schlanke bzw. dünne und gewichtsparende Konstruktion realisierbar. Des Weiteren ist es günstig, wenn ein Pixel beispielsweise 9 leuchtende Bereiche aufweist, welche vorzugsweise auf dem Substrat, auf welchem die Lichtquellen günstigerweise angebracht sind, quadratisch angeordnet sind.

Dabei ist es günstig, wenn jedes der 9 leuchtenden Bereiche des Pixels jeweils 3 Subpixel aufweist. Auf diese Weise kann ein Pixel mithilfe von 27 Subpixel Farben eines RGB-Farbraums erzeugen. Für die Pixel werden vorzugsweise LED oder OLED eingesetzt, welche bevorzugterweise ein Maß von 9 µm X 9 µm aufweisen, wobei selbstverständlich auch andere Maße möglich sind. Denkbar sind ebenfalls eine geringere oder größere Anzahl von Subpixeln sowie eine geringere oder größere Anzahl von leuchtenden Bereichen als den bereits vorgestellten.

Vorteilhafterweise ist jedem Pixel eine Leuchtfläche zugeordnet, wobei die Leuchtfläche insbesondere als Loch bzw. Bohrung ausgestaltet ist, und wobei der Abstand zwischen der Anzeigefläche mit ihren Leuchtflächen und den zu jeder Leuchtfläche zugehörigen Pixel bevorzugterweise zwischen 200 und 300 µm, besonders bevorzugt bei 200, 250 oder 300 µm liegt.

Auf diese Weise kann mit den Leuchtflächen eine Parallaxbarriere erzeugt werden, wobei vorzugsweise die Leuchtfläche als Loch bzw. Bohrung ausgestaltet ist, das bevorzugterweise einen Durchmesser von 5 bis 15 µm, besonders bevorzugt einen Durchmesser von 10 µm aufweist. Somit kann in Abhängigkeit des Winkels, in welchem die Anzeigevorrichtung mit ihrer Anzeigefläche relativ zu einem Betrachter orientiert ist, vorzugsweise Licht lediglich eines der 9 leuchtenden Bereiche des Pixels durch die Leuchtfläche bzw. das Loch zu dem Betrachter gelangen. Aufgrund der vorgenannten Maße ist es möglich verschiedene Bilder für jedes Auge eines Betrachters zu generieren, wodurch ein dreidimensionaler Effekt erzeugt wird. Logischerweise gelangen durch Bewegung der Anzeigevorrichtung bzw. durch die Orientierung der Anzeigefläche der Anzeigevorrichtung relativ zum Betrachter unterschiedlich leuchtende Bereiche des Pixels zum Betrachter, sodass über einen großen Winkelbereich ein dreidimensionales Bild mittels der Anzeigevorrichtung realisierbar ist.

Bei einer konkreten Ausführung kann bei 80 µm X 80 µm pro Pixel, vorzugsweise im Bereich zwischen 50 µm und 80 µm pro Pixel, und einem beispielsweise Abstand von 10 µm zwischen den Pixeln eine hohe Auflösung für eine zu generierende dreidimensionale Ansicht erzeugt werden. Auf diese Weise erhält also ein Betrachter der Anzeigevorrichtung einen hochauflösenden dreidimensionalen Eindruck eines auf der Anzeigevorrichtung dargestellten Objekts sowohl in horizontaler als auch in vertikaler Richtung. Ferner ist diese hohe Auflösung der generierten dreidimensionalen Ansicht über einen großen Winkelbereich verfügbar, wobei unter dem Begriff Winkelbereich die relative räumliche Orientierung der Anzeigevorrichtung bzw. deren Anzeigefläche zu dem Betrachter bzw. dessen Blickrichtung verstanden wird. Durch diese bevorzugte Ausgestaltung der Leuchtflächen und Zuordnung zu den Lichtquellen ist eine besondere dreidimensionale Bilddarstellung, vergleichbar mit einer autostereoskopischen Bilddarstellung, möglich, wobei durch die Ausgestaltung der nicht leuchten Flächen aus Substratmaterial oder Füllmaterial insbesondere die reflektierenden Eigenschaften der nicht leuchtenden Flächen sehr gut einstellbar sind.

Ferner ist es von Vorteil, wenn eine Vielzahl von Löchern bzw. Bohrungen oder geformten Körpern auf einer Vielzahl von Leuchtflächen Streifenmasken oder ein Linsenraster bilden. Somit ist es auf einfache Weise möglich, ein 3D-Display, ähnlich einem autostereoskopischen 3D-Display zu realisieren. Unter einem autostereoskopischen 3D-Display wird die Anzeige von autostereoskopischen Bildern auf einer Anzeigevorrichtung verstanden.

Für einen dreidimensionalen Eindruck werden bei einer autostereoskopischen Anzeigevorrichtung zwei Bilder gleichzeitig dargestellt. Mithilfe mehrerer Parallaxbarrieren, beispielsweise realisiert als schräg gestellte Streifenmasken oder Linsenraster, wird das Licht einzelner Pixel in verschiedene Richtungen vor der Anzeigevorrichtung gelenkt und für jedes Auge eines Betrachters ein anderes Bild erzeugt.

Bevorzugt weist der geformte Körper einen Eingang und einen Ausgang auf. Bevorzugt weist der Ausgang eine größere Fläche auf als der Eingang. Bevorzugt ist der Ausgang der Leuchtfläche sowie der Anzeigefläche zugewandt und der Eingang ist der Beleuchtungseinrichtung zugewandt.

Bei einer weiteren erfindungsgemäßen Anzeigevorrichtung weist das Füllmaterial mindestens ein Funktionselement auf. Somit kann Füllmaterial eingespart und gleichzeitig die Funktionalität auf engem Raum erhöht werden. Durch diese Ausgestaltung ist also eine besonders effiziente Nutzung von zur Verfügung stehendem Bauraum möglich, wobei Füllmaterial auch vollständig durch z.B. einen Sensor oder ein Solarelement ersetzt werden kann. Somit wird wertvoller Raum, ausgefüllt von Füllmaterial, für weitere Funktionen nutzbar.

Bei einer weiteren erfindungsgemäßen Anzeigevorrichtung weist jede Lichtquelle einen Elektronen-Emitter auf, welcher eingerichtet ist, durch Aussendung eines Elektronenstrahls eine Leuchtstoffschicht zum aktiven Leuchten zu bringen, oder jede Lichtquelle weist einen UV-Emitter auf, welcher eingerichtet ist, durch Aussendung eines UV-Lichtstrahls die Leuchtstoffschicht zum aktiven Leuchten zu bringen.

Auf diese Weise sind sehr effiziente und spektral gut justierbare Lichtquellen realisiert. Insbesondere können durch die erfindungsgemäßen Flächenverhältnisse von nicht leuchtenden Flächen und Leuchtflächen die UV-Emitter und insbesondere die Elektronenemitter besser gegenseitig voneinander getrennt werden, was besonders bei Elektronenemittern, die jeweils eine eigene Vakuumzelle benötigen, besonders vorteilhaft ist. Unter UV-Emitter wird auch bevorzugt ein Emitter, der im blauen bis violetten Bereich (mit oder ohne UV-Bereich) abstrahlt, verstanden. Bei Elektronenemittern ist Vakuum notwendig und den Abstand zwischen den Leuchtflächen dieser Erfindung kann somit dazu benutzt werden um Abstandhalter einzubauen, was im Stand der Technik sehr schwierig ist, weil die leuchtenden Flächen sehr groß sind bzw. so groß wie möglich sind und Abstandhalter störend (z.B. Schattenwurf) wirken.

Bei einer weiteren erfindungsgemäßen Anzeigevorrichtung weist die Anzeigevorrichtung eine Beleuchtungseinrichtung mit einer Lichtquelle oder mit mehreren Lichtquellen auf und die aktive Leuchtfläche der Lichtquelle oder, wenn die Beleuchtungseinrichtung mehrere Lichtquellen aufweist, jeweils die aktiven Leuchtflächen der Lichtquellen weisen einen Flächeninhalt auf, der größer als die Flächeninhalte der Leuchtflächen der Anzeigefläche ist.

Hierdurch ist eine Erzeugung des Lichts auf einer größeren Fläche als die Größe der Leuchtflächen möglich, und somit ist, bevorzugt mit zusätzlicher Konzentration des Lichts auf die kleineren Leuchtflächen, eine höhere Strahlungsdichte innerhalb der Leuchtflächen erreichbar. Bevorzugt ist die Fläche der Beleuchtungseinrichtung oder die Summe der Flächen der Beleuchtungseinrichtung, welche Licht emittieren, größer als die Summe aller Flächeninhalte der Leuchtflächen. Bevorzugt ist die Gesamtausdehnung aller einer Leuchtfläche zugeordneten Lichtquellen größer als die Ausdehnung der Leuchtfläche. Bevorzugt sind die Lichtquellen polychromatisch und die Lichtquellen bzw. deren aktive Leuchtflächen weisen eine Ausdehnung auf, die mehr als 50%, bevorzugt mehr als 75% des Abstands der Flächenschwerpunkte der Leuchtflächen beträgt. Bevorzugt sind die Lichtquellen monochromatisch und die Lichtquellen bzw. deren aktive Leuchtflächen weisen eine Ausdehnung auf, die mehr als 50%, bevorzugt mehr als 75%, eines Drittels des Abstands der Flächenschwerpunkte der Leuchtflächen beträgt. Die aktive Leuchtfläche der Lichtquelle ist diejenige Fläche, welche aktiv leuchtet (z.B. die Fläche eines pn-Übergangs).

Bei einer weiteren erfindungsgemäßen Anzeigevorrichtung sind die Leuchtflächen jeweils durch ein von der Beleuchtungseinrichtung beleuchtbares optisches Streuelement oder transparentes Abdeckelement oder optisches Farbfilterelement gebildet und die nicht leuchtenden Flächen der Anzeigefläche sind durch Flächen eines zwischen den Leuchtflächen angeordneten Füllmaterials oder Substrats gebildet.

Durch diese bevorzugte Ausgestaltung der Leuchtflächen und Zuordnung zu der Beleuchtungseinrichtung ist wiederum eine besonders effiziente Bilddarstellung möglich. Durch die Ausgestaltung der nicht leuchten Flächen aus Substratmaterial oder Füllmaterial sind insbesondere die reflektierenden Eigenschaften der nicht leuchtenden Flächen sehr gut einstellbar. Das Streuelement ist bevorzugt ein wie zuvor detaillierter beschriebenes Streuelement.

Erfindungsgemäß weist die Anzeigevorrichtung optische Strahlformeinrichtungen auf, die zwischen der Beleuchtungseinrichtung und der Anzeigefläche angeordnet sind, und jeder Strahlformeinrichtung ist, bevorzugt mindestens oder genau, eine Leuchtfläche zugeordnet und die Strahlformeinrichtungen sind jeweils eingerichtet, Licht von der Beleuchtungseinrichtung auf die jeweilige Leuchtfläche zu konzentrieren.

Hierdurch kann Licht auf die Leuchtflächen mittels einer Strahlformung konzentriert werden, wodurch die maximal erreichbare Helligkeit erhöht wird. Die optischen Strahlformelemente sind bevorzugt eingerichtet, Licht aus der Beleuchtungseinrichtung auf eine Leuchtfläche zu konzentrieren und/oder zu fokussieren. Bevorzugt weisen eine oder mehrere Strahlformeinrichtungen am Ausgang eine Spitze oder ein rohrförmiges oder zylindrisches Endstück (sozusagen ein "Lightguide"), z.B. ein Glasfaserstück auf, besonders bevorzugt mit einer abschließenden Diffusionsschicht.

Ein Strahlformelement ist bevorzugt dann einer Leuchtfläche zugeordnet, wenn Licht aus dem Strahlformelement kommend durch die Leuchtfläche propagiert. Die Ausdehnung der Strahlformelemente entlang der optischen Achse beträgt bevorzugt weniger als 3 mm, besonders bevorzugt weniger als 1 mm, ganz besonders bevorzugt weniger als 0,5 mm oder noch bevorzugter weniger als 0,25 mm. Die Strahlformelemente sind bevorzugt gegossen oder mittels Laserlithographie hergestellt. Bevorzugt bilden sie ein Array aus Strahlformelementen. Bevorzugt ist jedem optischen Strahlformelement mindestens eine Lichtquelle der Beleuchtungseinrichtung zugeordnet.

Durch die Lichtkonzentration der Strahlformeinrichtung (z.B. mittels einer Linse oder einem Lightguide, z.B. eine Glasfaser) ist eine Überbrückung des Abstands zwischen den Lichtquellen und den Leuchtflächen sehr effizient möglich. Bevorzugt weist die Strahlformeinrichtung eine Ausdehnung in Richtung entlang der Anzeigefläche oder des Substrats auf, die größer ist als die einer Lichtquelle, besonders bevorzugt ist die Ausdehnung so groß wie der Abstand der Flächenschwerpunkte benachbarter Leuchtflächen.

Bei einer weiteren erfindungsgemäßen Anzeigevorrichtung weisen die optischen Strahlformeinrichtungen jeweils einen optischen Kollimator auf.

Hierdurch kann das Licht der Lichtquelle eingesammelt und in eine Richtung gelenkt werden. Als Kollimator sind z.B. eine Kollimatorfolie (Mikroprismenfolie, Mikropyramidenfolie, Microspherefolie) und/oder ein (Parabol-/Ellipsen-)Reflektor mit der Lichtquelle bevorzugt im Brennpunkt und/oder (Mikro-)Linsen (Fresnel oder herkömmlich) vorgesehen oder allgemein eine kollimierende reflektive oder transmissive Optik. Ein Kollimator ist bevorzugt eingerichtet, den Abstrahlwinkel einer Lichtquelle der Beleuchtungseinrichtung über Strahlumlenkung zur optischen Achse hin zu verringern.

Erfingungsgemäß weisen die optischen Strahlformeinrichtungen jeweils einen optischen Konzentrator auf.

Durch diesen Teil der Strahlformeinrichtung wird das Licht auf die Leuchtfläche effektiv konzentriert. Als Konzentrator ist z.B. ein (üblicherweise nicht abbildender) Compound Parabolic Conentrator (CPC) vorgesehen und/oder photonische Kristalle oder allgemein eine fokussierende oder konzentrierende reflektive oder transmissive Optik wie z.B. auch eine (abbildende oder nicht abbildende) Kondensor- oder Fresnellinse. Bevorzugt ist der Konzentrator eine nicht abbildende Optik, wodurch eine höhere Effizienz der Konzentration und eine Intensitätshomogenisierung erreichbar ist. Der der Beleuchtungseinrichtung zugewandte Eingang des optischen Konzentrators weist bevorzugt eine größere Fläche auf (z.B. im Durchmesser oder in der Diagonale 80 µm) als der einer Leuchtfläche zugewandte Ausgang des optischen Konzentrators (z.B. im Durchmesser oder in der Diagonale 8 µm). Dies gilt bevorzugt für jeden optischen Konzentrator. Bevorzugt weist der Eingang eine Fläche auf, die so groß und gleichermaßen geformt ist, wie die lichtemittierenden Flächen der dem Konzentrator zugeordneten Lichtquelle oder Lichtquellen. Hierdurch wird Licht von einer größeren Eintrittsfläche auf eine kleine Leuchtfläche konzentriert. Bevorzugt weist der Konzentrator einen Eingang und einen Ausgang auf. Bevorzugt weist der Eingang eine größere Fläche auf als der Ausgang. Bevorzugt ist der Ausgang der Leuchtfläche sowie der Anzeigefläche zugewandt und der Eingang ist der Beleuchtungseinrichtung zugewandt. Der Konzentrator weist bevorzugt einen optischen Eingangswinkel auf, welcher maximal um 30°, bevorzugt maximal um 10° kleiner ist, als der optische Ausgangswinkel des Kollimators. Besonders bevorzugt ist der optische Eingangswinkel des Konzentrators gleich oder größer als der Ausgangswinkel des Kollimators.

Bei einer weiteren erfindungsgemäßen Anzeigevorrichtung ist der optische Kollimator bezüglich einer Propagationsrichtung des Lichts der Beleuchtungseinrichtung vor dem Konzentrator angeordnet, so dass Licht zunächst im Wesentlichen kollimierbar und dann konzentrierbar ist.

Hierdurch ist eine besonders effektive Strahlformung möglich. Besonders bevorzugt sind optischer Kollimator und optischer Konzentrator in einem Element vereint. Hierdurch können Streulichtverluste minimiert werden.

Bei der erfindungsgemäßen Anzeigevorrichtung weisen die optischen Strahlformeinrichtungen mindestens eine gekrümmte oder abgestufte Reflektorfläche auf. Durch gekrümmte oder abgestufte Reflektorflächen ist das Licht mit einem enorm erhöhten Wirkungsgrad auf die Leuchtflächen leitbar, insbesondere durch Ausnutzen des Phänomens der Totalreflexion. Bevorzugt handelt es sich um parabolisch oder elliptisch gekrümmte Flächen (z.B. eines CPC) oder um einen Facettenspiegel.

Bei einer weiteren erfindungsgemäßen Anzeigevorrichtung ist mindestens ein Funktionselement zwischen der Beleuchtungseinrichtung und der Anzeigefläche angeordnet. Ferner ist bei einer weiteren erfindungsgemäßen Anzeigevorrichtung das mindestens eine Funktionselement zwischen mindestens zwei optischen Strahlformeinrichtungen angeordnet, vorzugsweise in dem Raum zwischen zwei optischen Strahlformeinrichtungen.

Die vorgenannten Anordnungen erlauben den Raum zwischen der Beleuchtungseinrichtung und der Anzeigefläche sowie zwischen mindestens zwei optischen Strahlformeinrichtungen für das mindestens eine Funktionselement zu nutzen. Hierdurch ist es möglich die Bauhöhe zu begrenzen und somit eine Bauschicht für z.B. ein Funktionselement einzusparen. Dadurch verringert sich die Höhe sowie das Gewicht der zu bildenden Anzeigevorrichtung mit mindestens einem Funktionselement.

Bei einer weiteren erfindungsgemäßen Anzeigevorrichtung weist das mindestens eine Funktionselement, das zwischen zwei optischen Strahlformeinrichtungen angeordnet ist, eine polygone oder polyedrische Form auf, wobei die polygone oder polyedrische Form die Oberfläche der nicht leuchtenden Fläche zwischen zwei Leuchtflächen vergrößert. Mithilfe der Vergrößerung der Oberfläche steht eine größere Fläche für beispielsweise ein Solarelement zur Verfügung, welches dem Umwandeln von Sonnenenergie in elektrische Energie dient. Aufgrund der vergrößerten Oberfläche kann mehr Energie erzeugt bzw. umgewandelt werden, wodurch die Effizienz einer Anzeigevorrichtung mit mindestens einem Funktionselement gesteigert wird.

Selbstverständlich ist es möglich, dass mehrere unterschiedliche Funktionen, wie z.B. ein Temperatursensor, ein Abstandssensor, ein Drucksensor, ein Gassensor und/oder ein Bildsensor in dem mindestens einem Funktionselement vereint sind.

Bei einer weiteren erfindungsgemäßen Anzeigevorrichtung ist es möglich, dass in einer einzigen Leuchtfläche die vorbeschriebenen Eigenschaften und Vorteile des Funktionselements zusammen mit einer Lichtquelle vereint sind. Das bedeutet, dass sich ein Funktionselement und eine Lichtquelle eine Leuchtfläche teilen, wodurch eine weitere Miniaturisierung ermöglicht wird. Folglich kann sowohl ein Sensor als auch eine Lichtquelle einer Leuchtfläche zugeordnet sein. Die vorbeschriebenen Merkmale und Vorteile der Lichtquelle, der Leuchtfläche sowie des Funktionselements sind bei dieser erfindungsgemäßen Anzeigevorrichtung analog anwendbar.

Weiterhin wird die Aufgabe der Erfindung insbesondere gelöst durch ein Verfahren zur Darstellung eines Bilds auf einer Anzeigevorrichtung, wobei eine erfindungsgemäße Anzeigevorrichtung verwendet wird.

Die Erfindung soll nun anhand von Zeichnungen beispielhaft weiter veranschaulicht werden. Hierbei zeigen:
**Fig. 1** einen vergrößerten Ausschnitt einer Anzeigevorrichtung, bei welcher der Anteil von nicht leuchtenden Flächen an der Anzeigefläche mehr als 70% beträgt,
**Fig. 2** eine rein qualitative Veranschaulichung eines Abstands, der kleiner ist als das Auflösungsvermögen des Betrachters und der bei dem Betrachter unter einem Winkel von maximal zwei Winkelminuten erscheint,
**Fig. 3a und 3b** Ausschnitte Anzeigevorrichtungen aufbauend auf Fig. 1 wobei die Anzeigevorrichtung eine Farbanzeigevorrichtung ist,
**Fig. 4a bis 6d****,** wie auf verschiedene Weise die zweidimensionale Struktur einer Anzeigefläche gemäß dem Prinzip, einen Anteil von nicht leuchtenden Flächen an der gesamten Anzeigefläche von mehr als 70% vorzusehen, erhalten werden kann, wobei

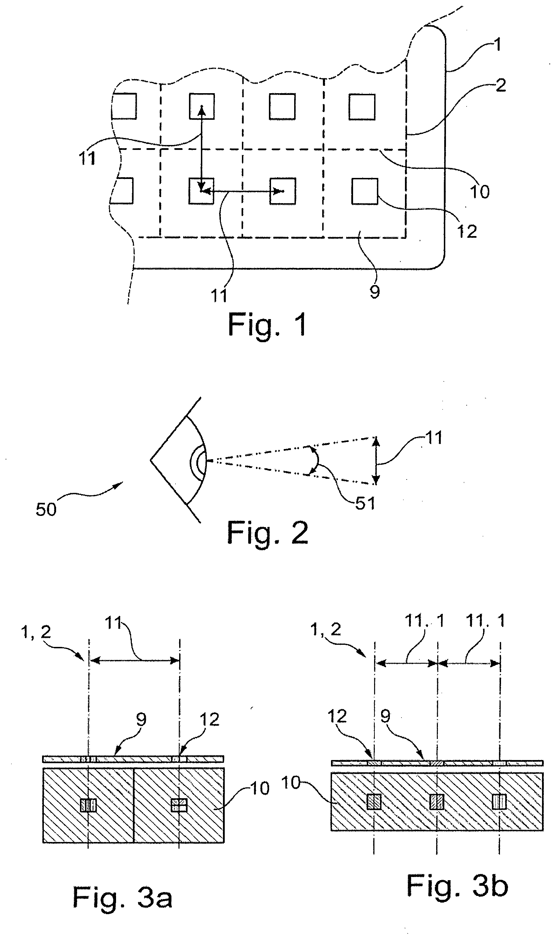

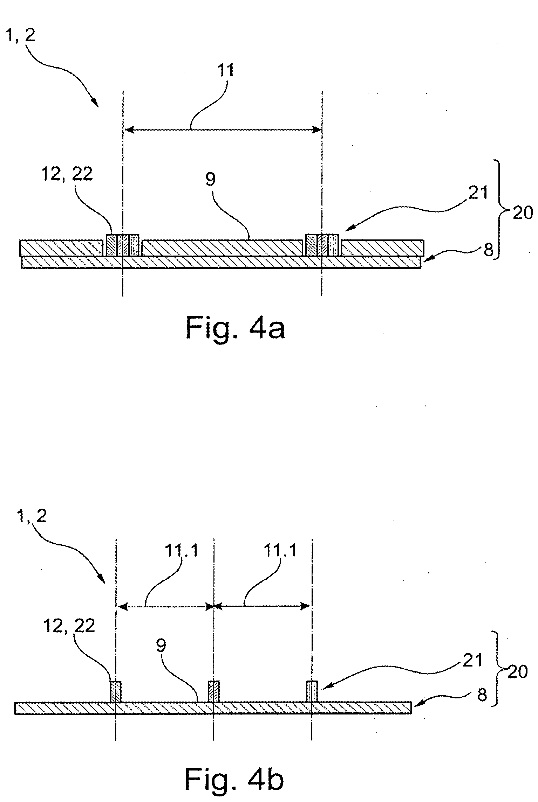

**Fig. 4a bis 4e** Ausschnitte von Anzeigevorrichtungen aufbauend auf Fig. 3a oder 3b zeigen, wobei die Anzeigevorrichtung eine Beleuchtungseinrichtung mit einem Substrat aufweist, auf dem mehrere Lichtquellen angeordnet sind, wobei dabei bevorzugt die Lichtquellen kleine Lichtquellen sind (z.B. VCSEL-Laser), d.h. bevorzugt Lichtquellen, bei denen der Flächeninhalt der aktiven Leuchtfläche kleiner oder gleich dem Flächeninhalt der entsprechenden Leuchtfläche ist, und wobei

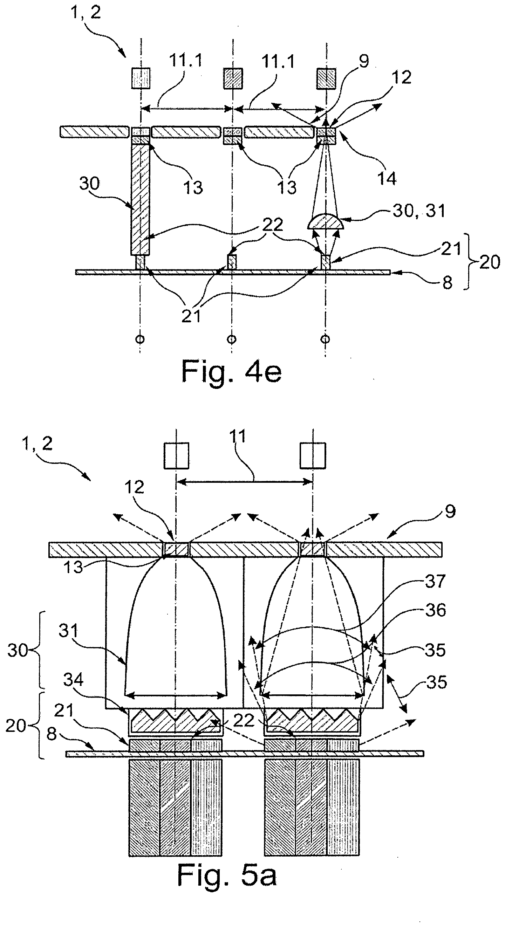

**Fig. 5a bis 6d** Ausschnitte erfindungsgemäßer Anzeigevorrichtungen aufbauend auf Fig. 3a oder 3b zeigen, wobei diese im Vergleich zu Fig. 4a-4e größere Lichtquellen aufweisen und insbesondere jeweils optische Strahlformeinrichtungen, die zwischen der Beleuchtungseinrichtung und der Anzeigefläche angeordnet sind, und wobei jeder Strahlformeinrichtung eine Leuchtfläche zugeordnet ist und die Strahlformeinrichtungen jeweils eingerichtet sind, Licht von der Beleuchtungseinrichtung auf die jeweilige Leuchtfläche zu konzentrieren.

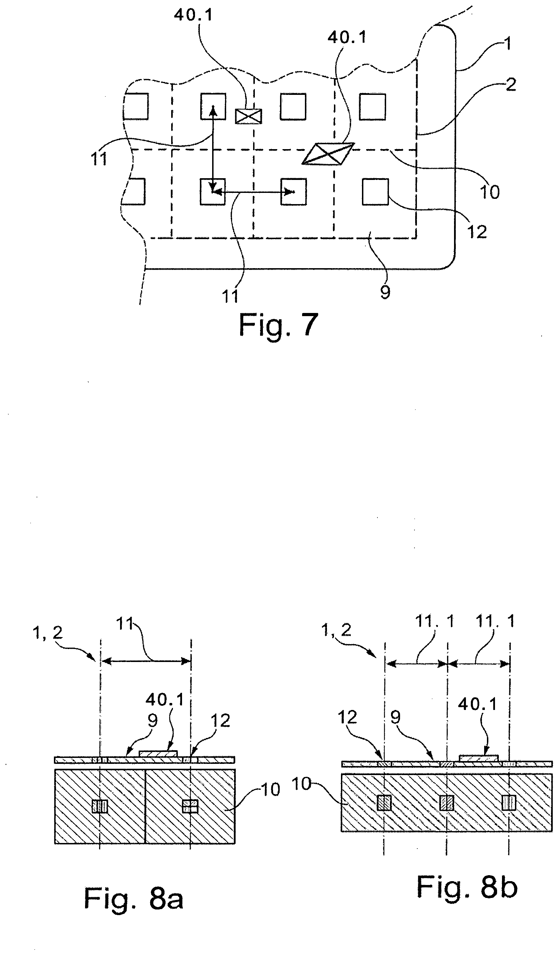

**Fig. 7** den vergrößerten Ausschnitt einer erfindungsgemäßen Anzeigevorrichtung von Fig. 1, ergänzt um Funktionselemente,
**Fig. 8a und 8b** Ausschnitte erfindungsgemäßer Anzeigevorrichtungen von Fig. 3a und 3b mit jeweils einem Funktionselement,

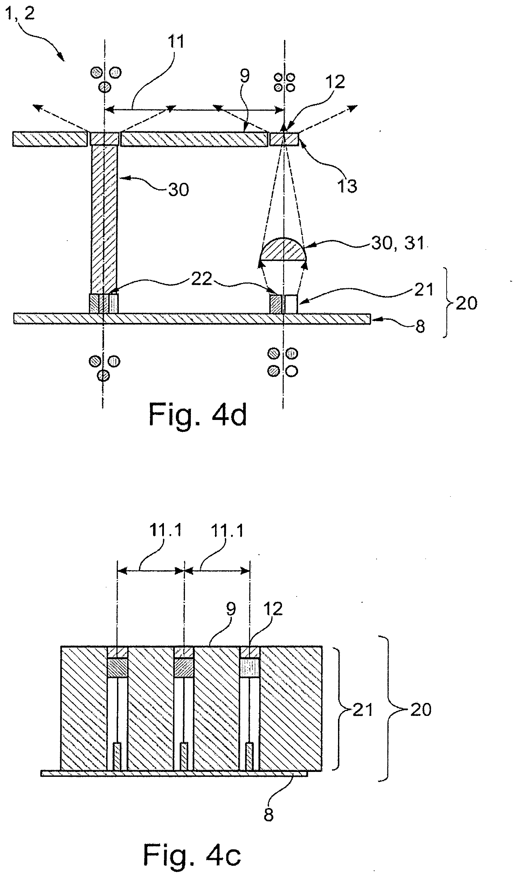

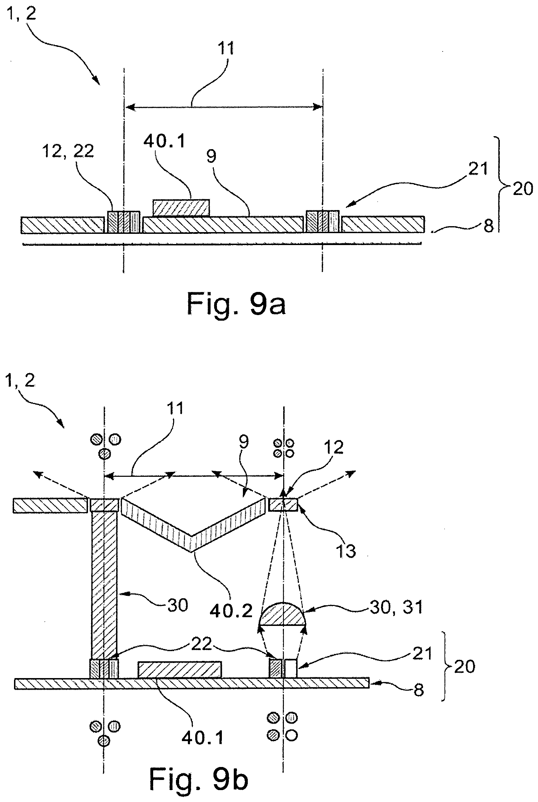

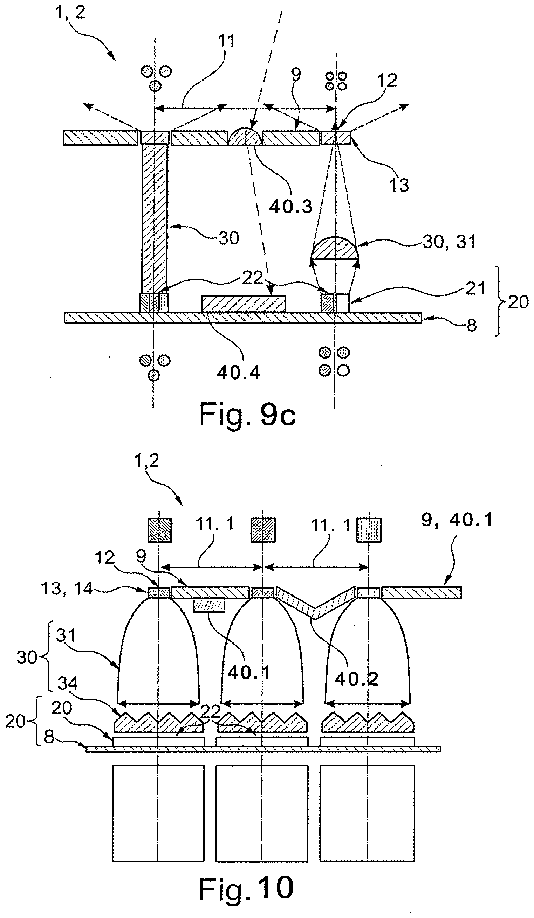

**Fig. 9a, 9b** **und** **9c** die Figur 4a und zweimal die Figur 4d in Ergänzung um Funktionselemente, und

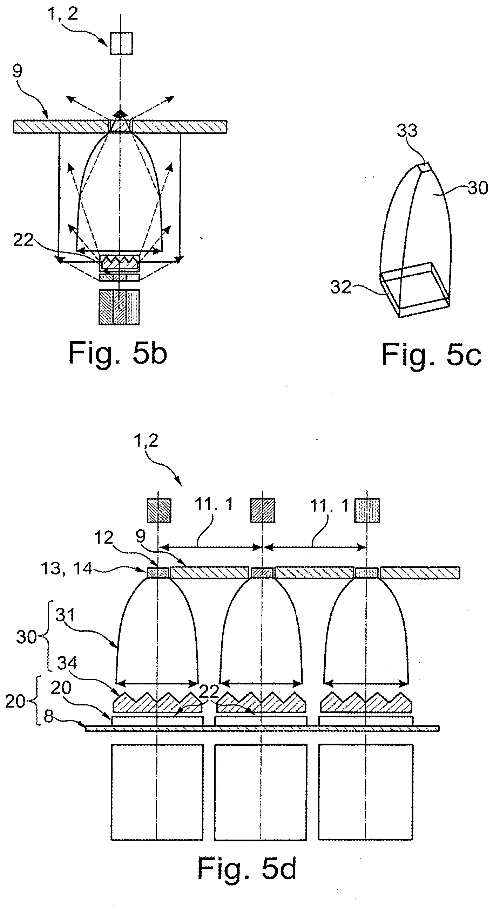

**Fig. 10** die Figur 5d mit Funktionselementen.

**Fig. 1** zeigt einen vergrößerten Ausschnitt einer Anzeigevorrichtung 1, bei welcher der Anteil von nicht leuchtenden Flächen 9 an der gesamten Anzeigefläche 2 mehr als 70% beträgt. Die Anzeigevorrichtung 1 weist eine Anzeigefläche 2 (Grenze = gestrichelte Linie mit den längsten Strichen) auf, die aus nicht leuchtenden Flächen 9 und Leuchtflächen 12 besteht. Die Flächenschwerpunkte benachbarter Leuchtflächen 12 weisen gegenseitige Abstände 11 auf, die kleiner sind, als das Auflösungsvermögen eines Betrachters. Dieses Beispiel zeigt außerdem, dass eine oder mehrere Leuchtflächen 12 einem Pixel 10 (Pixelgrenze = gestrichelte Linie mit mittlerer Strichlänge) zugeordnet sind und die Anzeigefläche 2 eine Vielzahl solcher Pixel 10 aufweist, die in einem sich wiederholenden Muster angeordnet sind, so dass aus den Pixeln 10 Bilder zusammengesetzt werden können.

Ein sehr großer Vorteil besteht darin, dass die Leuchtflächen 12 durch große Trennbereiche, die durch nicht leuchtende Flächen 9 gebildet sind, voneinander getrennt sind und sich somit einerseits kein Streuleuchten von einer auf die andere Leuchtfläche 12 ergibt (oder dieses stark reduziert wird) und dass andererseits dunkle Bereiche eines durch die Anzeigevorrichtung 1 dargestellten Bilds noch dunkler wirken können, da die nicht leuchtenden Flächen 9 überwiegen.

**Fig. 2** zeigt eine rein qualitative Veranschaulichung eines Abstands 11, der kleiner ist als das Auflösungsvermögen des Betrachters 50 und der bei dem Betrachter unter einem Winkel 51 von maximal zwei Winkelminuten erscheint. Bei einem solchen Abstand 11 können die meisten Betrachter 50 zwei verschiedene Pixel 10 nicht mehr wahrnehmen und sie erhalten somit einen besonders hochwertigen und kontinuierlichen Bildeindruck.

In den nachfolgenden Figuren sind verschiedene Ausgestaltungsmöglichkeiten aus Platzgründen auch innerhalb einer Anzeigevorrichtung 1 gezeigt, was nicht einschränkend zu werten ist. Es bedeuten, dass die entsprechende Anzeigevorrichtung bevorzugt nur eine Form der gezeigten Ausgestaltungsmöglichkeiten (angewendet auf alle Leuchtflächen / Pixel) aufweist oder eine Mischung verschiedener Ausgestaltungsmöglichkeiten (z.B. wie dann dargestellt).

**Fig. 3a und 3b** zeigen Ausschnitte von Anzeigevorrichtungen 2 aufbauend auf Fig. 1 wobei die Anzeigevorrichtung 1 eine Farbanzeigevorrichtung ist. Es ist jeweils eine Seitenansicht oberhalb einer Aufsicht auf die Anzeigefläche 2 gezeigt. Zur besseren Veranschaulichung und Farbunterscheidung sind aber hier Schraffuren verwendet. In **Fig. 3a** sind zwei Pixel 10 gezeigt. Es ist jeweils eine Leuchtfläche 12 einem Pixel 10 zugeordnet, wobei über die Leuchtfläche 12 mehrere Farben an den Betrachter ausgesendet werden. Zwei Möglichkeiten der Zusammensetzung eines Pixels 10 sind dargestellt, links eine Zusammensetzung eines Pixels 10 aus den Farben Rot (enge Schraffur von links oben nach rechts unten), Grün (enge Schraffur von links unten nach rechts oben), Blau (enge Schraffur vertikal) bevorzugt in Streifenanordnung und rechts aus den Farben Rot, Grün, Blau und Weiß (ohne Schraffur) bevorzugt in annähernd quadratischer Anordnung. Komponenten mit einer weiten Schraffur von links oben nach links unten, so wie hier die nicht leuchtenden Flächen 9, sind bevorzugt lichtundurchlässig.

In **Fig. 3b** ist ein Pixel 10 dargestellt, dem drei Leuchtflächen 12 zugeordnet sind, wobei über eine erste Leuchtfläche 12 Rot, über eine zweite Leuchtfläche 12 Grün und über eine dritte Leuchtfläche 12 Blau an den Betrachter aussendbar ist Die Abstände 11.1 der Flächenschwerpunkte benachbarter Leuchtflächen 12 betragen 1/3 des Abstands 11, der kleiner ist als das Auflösungsvermögen des Betrachters 50.

**Fig. 4a** bis 6d zeigen, wie auf verschiedene Weise die zweidimensionale Struktur einer Anzeigefläche 2 gemäß dem Prinzip, einen Anteil von nicht leuchtenden Flächen 9 an der gesamten Anzeigefläche 2 von mehr als 70% vorzusehen, erhalten werden kann. Optische Achsen sind jeweils gestrichpunktet eingezeichnet und teilweise ist am unteren Ende der Achse ein bevorzugtes Leuchtmuster bzw. -Farbe der entsprechenden Lichtquelle 21 angegeben und am oberen Ende der Achse ein sich bevorzugt ergebendes Leuchtmuster bzw. -farbe auf der Leuchtfläche 12.

**Fig. 4a** bis 4e zeigen Ausschnitte erfindungsgemäßer Anzeigevorrichtungen 1 aufbauend auf Fig. 3a oder 3b. Die Anzeigevorrichtung 1 weist eine Beleuchtungseinrichtung 20 mit einem Substrat 8 auf, auf dem mehrere Lichtquellen 21 angeordnet sind, wobei dabei bevorzugt die Lichtquellen 21 kleine Lichtquellen 21 sind (z.B. VCSEL-Laser), d.h. bevorzugt Lichtquellen 21, bei denen der Flächeninhalt der aktiven Leuchtfläche 22 kleiner oder gleich dem Flächeninhalt der entsprechenden Leuchtfläche 12 ist. Fig. 4a und 4d zeigen Lichtquellen 21, die polychromatisch sind, d.h. die eingerichtet sind, verschiedene, variable Anteile von Licht mit verschiedenen Wellenlängen zu emittieren, z.B. Rot, Grün, Blau-Anteile. Fig. 4b, 4c und 4e zeigen Lichtquellen 21, die monochromatisch sind, d.h. die einen nicht variablen Wellenlängenbereich bzw. festen Mix verschiedener Wellenlängen emittieren.

In **Fig. 4a** sind die Leuchtflächen 12 jeweils durch eine der Lichtquellen 21 gebildet. Die nicht leuchtenden Flächen 9 der Anzeigefläche 2 sind durch Flächen eines Füllmaterials zwischen den Lichtquellen 21 gebildet, was genauso auch bei Fig. 4b so vorgesehen sein könnte. **In** **Fig. 4b** sind die Leuchtflächen 12 jeweils durch eine der Lichtquellen 21 gebildet. Die nicht leuchtenden Flächen 9 der Anzeigefläche 2 sind durch Flächen des Substrats 8 gebildet, was genauso auch bei Fig. 4a so vorgesehen sein könnte. In **Fig. 4a und 4b** ist die aktive Leuchtfläche 22 der jeweiligen Lichtquelle 21 somit gleichermaßen eine Leuchtfläche 12 der Anzeigefläche 2. Mit wenigen Bauteilen kann somit eine Anzeigevorrichtung hergestellt werden, wobei dafür jedoch vorteilhafterweise qualitativ sehr hochwertige, helle und präzise abgemessene Lichtquellen verwendet werden sollten.

In **Fig. 4c** sind die Leuchtflächen 12 jeweils durch ein von einer der Lichtquellen 21 beleuchtbares transparentes Abdeckelement gebildet. Die nicht leuchtenden Flächen 9 der Anzeigefläche 2 sind durch Flächen eines Füllmaterials zwischen den Lichtquellen 21 gebildet. Jede Lichtquelle 21 weist eine Leuchtstoffschicht und einen Elektronen-Emitter auf, welcher eingerichtet ist, durch Aussendung eines Elektronenstrahls die Leuchtstoffschicht zum aktiven Leuchten zu bringen. Die Leuchtstoffschicht kann dabei auch als Streuelement angesehen werden, da es die eintreffende Strahlungsenergie aus einer Richtung in mehrere Richtungen verteilt. Zwischen dem Elektronen-Emitter und der Leuchtstoffschicht liegt jeweils ein Vakuum in einer Vakuumzelle vor.

Vorteilhaft dabei ist, dass aufgrund des erfinderischen Prinzips einer großen Zwischenfläche zwischen den Leuchtflächen auch eine sehr gute und günstige Abdichtung der Vakuumzellen möglich ist.

In **Fig. 4d** sind die Leuchtflächen 12 jeweils durch ein von einer der Lichtquellen 21 beleuchtbares optisches Streuelement 13 (weite Schraffur von links unten nach rechts oben - diese Art Schraffur bedeutet bevorzugt, dass die derart schraffierte Komponente, z.B. auch später Linsen, lichtdurchlässig, bevorzugt im Wesentlichen ohne Farbfilterung, ist) gebildet. Die nicht leuchtenden Flächen 9 der Anzeigefläche 2 sind durch Flächen eines Füllmaterials zwischen den Lichtquellen 21, auf Höher der Streuelemente 12, gebildet. Es sind zwei Ausgestaltungsmöglichkeiten gezeigt, links mit einem sog. Light-Guide (z.B. eine Glasfaser) als Strahlformeinrichtung 30, die auch als Konzentrator 31 dient, rechts mit einer Linse als Konzentrator 31. Das sich ergebende Leuchtmuster auf der Leuchtfläche 12 ist wie oben angedeutet, links etwa in gleicher Größe wie das Leuchtmuster der Leuchtfläche 22, rechts etwas verkleinert. Zudem ist das sich ergebende Leuchtmuster diffuser, bevorzugt mit untereinander durchmischten Farben, was aufgrund des Streuelements 13 erfolgt, zeichnungstechnisch jedoch nicht vorteilhaft darstellbar ist. Hierdurch wird eine gestreute Abstrahlung erreicht, gleichzeitig jedoch eine Bündelung des Lichts auf die Streuelemente 13.

**In** **Fig. 4e** sind die Leuchtflächen 12 jeweils durch ein von einer der Lichtquellen 21 beleuchtbares optisches Farbfilterelement 14 gebildet. Die nicht leuchtenden Flächen 9 der Anzeigefläche 2 sind durch Flächen eines Füllmaterials zwischen den Lichtquellen 21, auf Höhe der Farbfilterelemente 14, gebildet. Jede Lichtquelle 21 weist einen UV-Emitter auf, welcher eingerichtet ist, durch Aussendung eines UV-Lichtstrahls eine Leuchtstoffschicht, die hier z.B. auch als Streuelement 13 wirkt, zum aktiven Leuchten zu bringen. Die verschiedenen Farben, hier RGB, werden somit durch die Farbfilterelemente 14 erhalten, z.B. durch Quantum Dots. Es sind weiterhin drei Ausgestaltungsmöglichkeiten gezeigt, links und rechts Strahlformelemente 30 wie in Fig. 4d und in der Mitte eine Variante ohne Strahlformelement 30.

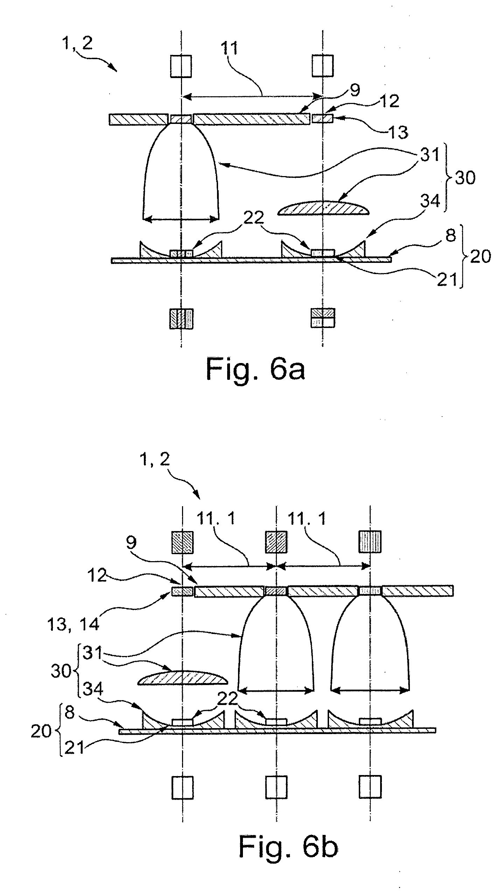

Bevorzugt ist in Fig. 4d und 4e ein Kollimator 34 Teil der Strahlformeinrichtung 30, analog zu z.B. Fig. 6a.

**Fig. 5a bis 6d** zeigen Ausschnitte erfindungsgemäßer Anzeigevorrichtungen 1 aufbauend auf Fig. 3a oder 3b. Diese weisen im Vergleich zu Fig. 4a-4e größere Lichtquellen 21 auf und insbesondere jeweils optische Strahlformeinrichtungen 30, die zwischen der Beleuchtungseinrichtung 20 und der Anzeigefläche 2 angeordnet sind, und jeder Strahlformeinrichtung 30 ist eine Leuchtfläche 12 zugeordnet und die Strahlformeinrichtungen 30 sind jeweils eingerichtet, Licht von der Beleuchtungseinrichtung 20 auf die jeweilige Leuchtfläche12 zu konzentrieren. Die aktiven Leuchtflächen 22 der Lichtquellen 21 weisen jeweils einen Flächeninhalt auf, der größer als der jeweilige Flächeninhalt der Leuchtfläche 12 der Anzeigefläche 2 ist. Die Anzeigevorrichtungen 1 weisen jeweils optische Strahlformeinrichtungen 30 auf, die zwischen der Beleuchtungseinrichtung 20 und der Anzeigefläche 2 angeordnet sind, und jeder Strahlformeinrichtung 30 ist eine Leuchtfläche 12 zugeordnet und die Strahlformeinrichtungen 30 sind jeweils eingerichtet, Licht von der Beleuchtungseinrichtung 20 auf die jeweilige Leuchtfläche 12 zu konzentrieren. Die optischen Strahlformeinrichtungen 30 weisen jeweils einen optischen Kollimator 34 (z.B. eine halb-sphärische Kollimatorlinse) und einen optischen Konzentrator 31 mit gekrümmten Reflektorflächen auf und der optische Kollimator 34 ist jeweils bezüglich einer Propagationsrichtung des Lichts der Beleuchtungseinrichtung 20 vor dem Konzentrator 31 angeordnet, so dass Licht zunächst im wesentlichen kollimierbar und dann konzentrierbar ist. Als Konzentrator 31 ist einerseits ein compound parabolic concentrator (CPC) vorgesehen (abgebildet durch zwei gegenüberliegende gekrümmte, bevorzugt parabolisch gekrümmte Reflektorflächen und perspektivisch auch in Fig. 5c), alternativ eine Kondensorlinse 31 (z.B. Fig. 6a rechts). Als Kollimatoren 34 sind einerseits Prismenkollimatoren 34 (gezeichnet durch eine pyradmidiale Struktur) oder alternativ Reflektoren 34 (wie in Fig. 6a bis Fig. 6d) vorhanden.

In **Fig. 5a****,** **5b und 5d** weisen die Anzeigevorrichtungen 1 Lichtquellen 21 auf, die annähernd Lambert-Strahler sind. **In** **Fig. 5a** sind Leuchtflächen 12 jeweils durch ein von der Beleuchtungseinrichtung 20 beleuchtbares optisches Streuelement 13 gebildet. Die nicht leuchtenden Flächen 9 der Anzeigefläche 2 sind durch Flächen eines zwischen den Streuelementen 13 angeordneten Füllmaterials gebildet, wobei das Füllmaterial hier als Fläche dargestellt ist, jedoch ebenso zudem den Zwischenraum zwischen benachbarten Strahlformelementen 30 komplett ausfüllen kann. Die Lichtquellen sind polychromatisch und die Lichtquellen bzw. deren aktive Leuchtflächen weisen eine Ausdehnung auf, die mehr als 50% des Abstands 11 der Flächenschwerpunkte der Leuchtflächen 12 betragen. Die CPCs 31 weisen einen Eingang 32 und einen Ausgang 33 auf (siehe auch Fig. 5c), wobei der Eingang 32 eine größere Fläche aufweist als der Ausgang 33 und der Ausgang 33 der Leuchtfläche 12 sowie der Anzeigefläche 2 zugewandt ist und der Eingang 32 der Beleuchtungseinrichtung 20 zugewandt ist. Der CPC weist einen optischen Eingangswinkel 37 auf, welcher maximal um 30°-10°, bevorzugt 20°, kleiner ist, als der optische Ausgangswinkel 36 des Prismenkollimators 34. Somit können optische Verluste 35 möglichst minimiert werden. Durch die Kombination von Kollimator 34 und Konzentrator 31 findet eine effektive Lichtkonzentration auf die Leuchtflächen 12 statt. Zudem wird durch den CPC als nicht abbildende Optik eine sehr homogene Farbmischung erreicht, was durch die weißen Ausgangsleuchtmuster angedeutet ist. Das Streuelement 13 erlaubt einen großen Betrachtungswinkel. Der Strahlengang des Lichts ist durch gestrichelte Pfeile angedeutet. In **Fig. 5b** ist eine Variante der Anzeigevorrichtung aus Fig. 5a dargestellt, bei welcher die Ausdehnung der Lichtquelle 21 kleiner als 50% des Abstands 11, jedoch größer als die Ausdehnung der Leuchtfläche 12 ist. In Fig. 5d sind im Unterschied zu Fig. 5a die Lichtquellen monochromatisch und die Leuchtflächen 12 sind jeweils durch ein von der Beleuchtungseinrichtung 20 beleuchtbares optisches Farbfilterelement, das gleichzeitig ein Streuelement 13 ist, gebildet. Weiterhin ergeben sich Abstände 11.1 zwischen den Leuchtflächen 12, die ein Drittel des Abstands 11 betragen.

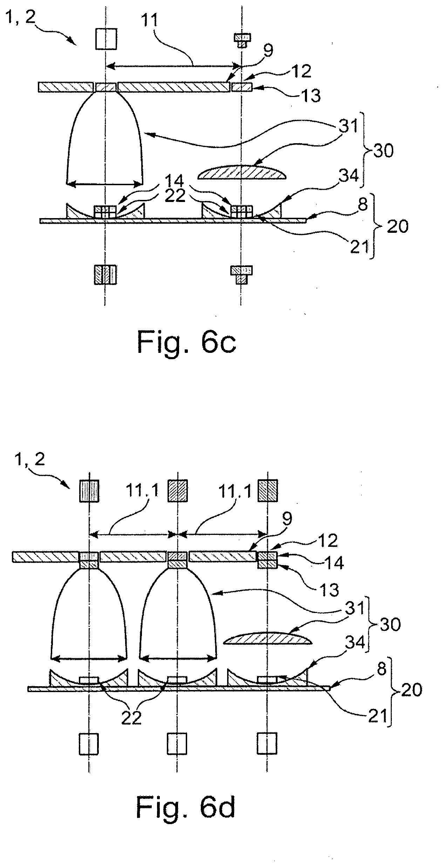

In **Fig. 6a, 6b****,** **6c und 6d** weisen die Anzeigevorrichtungen 1 Lichtquellen 21 auf, die flächenmäßig (z.B. bezogen auf die aktive Leuchtfläche einer Lichtquelle) gleich groß oder größer als die Leuchtflächen 12 sind. Ansonsten ist **Fig. 6a** ähnlich zu Fig. 5a, wobei Fig. 6a im Unterschied zu Fig. 5a Kollimatoren 34 zeigt, welche als Parabolreflektor die Lichtquellen 21 umgeben. Der optische Kollimator 34 ist nach wie vor bezüglich einer Propagationsrichtung des Lichts der Beleuchtungseinrichtung 20 vor dem Konzentrator 31 angeordnet, so dass Licht zunächst im Wesentlichen kollimierbar und dann konzentrierbar ist. Als Variante ist rechts eine RGBW-Lichtquelle gezeigt sowie anstatt eines CPCs als Konzentrator 31 eine Kondensorlinse, hier eine nicht-abbildende Kondensorlinse, die ebenfalls eine gute Homogenisierung des durch die Leuchtfläche 12 durchstrahlenden Lichts bewirkt. **Fig. 6b** ist ähnlich zu Fig. 6a, wobei die Lichtquellen 21 monochromatisch sind und die Leuchtflächen 12 jeweils durch ein von der Beleuchtungseinrichtung 20 beleuchtbares optisches Farbfilterelement, das gleichzeitig ein Streuelement 13 ist, gebildet sind. Weiterhin ergeben sich Abstände 11.1 zwischen den Leuchtflächen 12, die ein Drittel des Abstands 11 betragen. **Fig. 6c** ist ähnlich zu Fig. 6a, wobei die Lichtquellen 21 monochromatisch, hier weiß, sind und direkt auf den Lichtquellen 21 Farbfilterelemente 14 angeordnet sind. Weiterhin ist rechts eine Ausgestaltungsmöglichkeit mit einer abbildenden Kondensorlinse 31 gezeigt. **Fig. 6d** ist ähnlich zu Fig. 6a, wobei die Lichtquellen 21 monochromatisch, hier z.B. im Wesentlichen Blau- und/oder UV-emittierend sind. Die Leuchtflächen 12 sind jeweils durch ein von der Beleuchtungseinrichtung 20 beleuchtbares optisches Farbfilterelement 14 gebildet. Jede Lichtquelle 21 weist einen Blau- und/oder UV-Emitter auf, welcher eingerichtet ist, durch Aussendung eines Blau- und/oder UV-Lichtstrahls eine Leuchtstoffschicht, die hier z.B. auch als Streuelement 13 wirkt, zum aktiven Leuchten zu bringen. Die verschiedenen Farben, hier RGB, werden somit durch die Farbfilterelemente 14 erhalten. Weiterhin ergeben sich Abstände 11.1 zwischen den Leuchtflächen 12, die ein Drittel des Abstands 11 betragen. Direkt auf den Lichtquellen 21 sind Farbfilterelemente 14 angeordnet (z.B. Quantum Dots).

Bezüglich **Fig. 7** wird auf die Beschreibung zu Fig. 1 verwiesen, wobei sich Fig. 7 dadurch unterscheidet, dass diese zusätzlich Funktionselemente 40.1 aufweist. Die dargestellten Funktionselemente 40.1 sind zwischen den Leuchtflächen 12 bzw. auf den nicht leuchtenden Flächen 9 angeordnet.

Die hier dargestellte Anordnung und Größe der Funktionselemente 40.1 ist beispielhaft zu verstehen. So können Funktionselemente 40.1 in einem sich wiederholenden Muster angeordnet sein, wodurch eine Vielzahl von Bereichen zwischen den Leuchtflächen 12 genutzt werden kann. Auch ist die Größe und Form der Funktionselemente 40.1 variabel. Selbstverständlich ist auch eine beliebige polygone Form möglich.

Die in Fig. 7 dargestellten Funktionselemente 40.1 können z.B. ein Solarelement und/oder ein Sensor sein. Bei einem Sensor kann es sich beispielsweise um einen Temperatursensor, einen Abstandssensor, einen Drucksensor, einen Gassensor oder einen Bildsensor handeln. Ein Solarelement dient dem Umwandeln von Sonnenenergie in elektrische Energie, wodurch die Energieversorgung der Anzeigevorrichtung durch beispielsweise Aufladen einer Batterie verlängert oder überhaupt erst ermöglicht wird.

Bezüglich der Beschreibung von **Fig. 8a und 8b** wird auf die Beschreibung der Figuren 3a und 3b verwiesen, welche hier analog anwendbar ist. Fig. 8a und 8b unterscheiden sich lediglich durch das Funktionselement 40.1, das auf der nicht leuchtenden Fläche 9 angeordnet ist. In Fig. 8a und 8b ist das Funktionselement 40.1 auf der Oberseite der Anzeigefläche 2 angebracht. Es ist aber auch möglich, die Funktionselemente 40.1 auf der Unterseite, also auf der einem Betrachter abgewandten Seite anzuordnen. Im konkreten Fall ist das Funktionselement 40.1 als Piezoelement ausgestaltet, genauer gesagt als Drucksensor. Mithilfe des Drucksensors kann z.B. ein Höhenmesser realisiert werden. Auch ist es mit einem Piezoelement möglich, ein haptisches Feedback in Form von Vibration zu erzeugen.

Betreffend die Beschreibung von **Fig. 9a** wird auf die Figurenbeschreibung von Fig. 4a verwiesen, die hier ebenfalls zutrifft. Ferner weist Fig. 9a eine Funktionselement 40.1 zwischen zwei Lichtquellen 21 der Beleuchtungseinrichtung 20 auf. Das Funktionselement 40.1 ist auf der nicht leuchtenden Fläche 9 angeordnet und als Gassensor ausgestaltet.

Die Beschreibung von Fig. 4d trifft ebenfalls auf die Beschreibung von **Fig. 9b** zu, wobei Fig. 9b um zwei Funktionselemente 40.1 und 40.2 erweitert ist. Während ein Funktionselement 40.1 auf dem Substrat 8 der Beleuchtungseinrichtung 20 zwischen zwei Lichtquellen 21 angeordnet und als kapazitiver Sensor ausgestaltet ist, bildet das andere Funktionselement 40.2 ein Solarelement. Um die Oberfläche des Funktionselements 40.2 bzw. des Solarelements zu vergrößern und somit die Energieausbeute zu steigern, weist das Funktionselement 40.2 eine polygone Form auf. Auch bildet das polygon geformte, dreieckförmige Funktionselement 40.2 die gesamte nicht leuchtenden Fläche 9 der Anzeigefläche 2 zwischen zwei Leuchtflächen 12. Mithilfe der vorbeschriebenen Ausgestaltung ist eine Nutzung des Raums zwischen den optischen Strahlformeinrichtungen 30, dem Substrat 8 und den Leuchtflächen 12 auf einfache Weise möglich, wodurch eine dünne und gewichtssparende Bauform realisiert wird. Selbstverständlich kann das Funktionselement 40.2 auch nur einen Teil der nicht leuchtenden Fläche 9 der Anzeigefläche 2 in Anspruch nehmen.

Ferner ist die Beschreibung von Fig. 4d auch auf die Beschreibung von **Fig. 9c** analog anwendbar, wobei Fig. 9c wie Figur 9b zwei Funktionselemente aufweist, von denen das Funktionselement 40.3 als Strahlformelement und das Funktionselement 40.4 als Strahldetektoreinrichtung ausgebildet ist.

Das Strahlformelement 40.3, welches lichtdurchlässig und aus durchsichtigem Material ausgebildet ist, ist zwischen den Leuchtflächen 12 und zwischen den nicht leuchtenden Flächen 9 angeordnet und lenkt hindurchgehendes Licht durch Brechung auf die Strahldetektoreinrichtung 40.4. Auf diese Weise ist die Realisierung einer plenoptischen Kamera möglich, die durch mehrere Funktionselemente 40.3 und 40.4 gebildet werden kann. Somit wird das verfügbare Licht einer Szene, das aus mehr als einer Richtung auf die Linse bzw. das Strahlformelement 40.3 trifft, auf die Strahldetektoreinrichtung 40.4 bzw. einen Bildsensor abgebildet.

Im Unterschied zu einer herkömmlichen Kamera erfasst eine plenoptische Kamera nicht nur die Position und Intensität eines Lichtstrahls, der auf einen Bildsensor bzw. die Strahldetektoreinrichtung 40.4 trifft, sondern auch die Richtung, aus welcher der Lichtstrahl einfällt. Somit kann eine sog. Lichtfeldmessung vorgenommen werden. Folglich ist es mithilfe der Ausgestaltung, dargestellt in Figur 9c, möglich, mehrere Linsen bzw. Strahlformelemente 40.3 vor mehreren Bildsensoren bzw. Strahldetektoreinrichtungen 40.4 auf einfache Weise anzuordnen.

Vorteilhaft an einer plenoptischen Kamera sind die hohe Schärfentiefe, kein Abwarten eines Fokussiervorgangs und eine nachträgliche Anpassung der Fokusebene eines aufgenommenen Objektes bzw. Bildes.

Das Strahlformelement 40.3 ist in Figur 9c zwischen zwei Leuchtflächen 12 angeordnet und halbkugelförmig ausgebildet, es kann jedoch auch eine andere Form - je nach Anwendungsfall - aufweisen. So sind z. B. auch polygone Formen möglich. Der Strahldetektoreinrichtung 40.4 ist auf dem Substrat 8 und zwischen zwei Lichtquellen 21 angeordnet und im vorliegenden Fall ein Lichtfeldsensor, welcher - wie zuvor beschrieben - die Position und Intensität, sondern auch die Richtung eines Lichtstrahls erfasst. Ein beispielhafter Lichtstrahl ist mit einer unterbrochenen Strichlinie dargestellt, welche auf das Strahlformelement 40.3 tritt, von diesem gebrochen und weiter auf die Strahldetektoreinrichtung 40.4 gelenkt wird.

Des Weiteren ist es mittels der dargestellten Anordnung der Funktionselemente 40.3 und 40.4 möglich, eine Fotokopie z. B. eines Gegenstandes zu erstellen, wodurch ebenfalls die Funktion einer gewöhnlichen Kamera realisiert werden kann.

Bezüglich der Beschreibung von **Fig. 10** wird auf die Beschreibung der Figuren 5a bis 5d und insbesondere Figur 5d verwiesen, welche hier ebenfalls Anwendung findet. Unterhalb der linken nicht leuchtenden Fläche 9 der Anzeigefläche 2 ist ein Funktionselement 40.1 angeordnet, wobei die rechte nicht leuchtende Fläche 9 identisch zu der Figur 9b ausgestaltet ist. Betreffend das polygon geformte Funktionselement 40.2 wird der Kürze halber auf die Beschreibung zu Figur 9b verwiesen, die hier ebenfalls anwendbar ist. Das linke Funktionselement 40.1 ist als Piezoelement ausgebildet, welches ein haptisches Feedback erzeugen kann und gleichzeitig als Drucksensor fungiert. Somit kann also eine Eingabe eines Nutzers auf der Anzeigevorrichtung 1 detektiert werden und gleichzeitig ein haptisches Feedback für die erfolgte Eingabe erzeugt werden.

Selbstverständlich ist es für die Ausführungen der Figuren 7 bis 10 möglich, dass mehrere unterschiedliche Funktionen, wie z.B. ein Gassensor und ein Drucksensor, in einem Funktionselement vereint sind.

In allen gezeigten Ausführungen weisen bevorzugt die nicht leuchtenden Flächen 9, bevorzugt die gesamte Anzeigefläche 2 einen Reflexionsgrad diffuser Reflexion und/oder spiegelnder Reflexion von weniger als 50 % auf. Die nicht leuchtenden Flächen 9 weisen hierfür bevorzugt eine dunkle Farbe auf oder sind schwarz und/oder sie weisen einen Mittenrauwert im Bereich von 0,2 µm und 1,0 µm auf und/oder sind mittels einer Antireflexbeschichtung beschichtet. Bevorzugt ist zudem eine elektronische Kompensationseinrichtung vorhanden, mittels welcher eine minimale Helligkeit der Leuchtflächen 12 für die Anpassung der Darstellung schwarzer Bildpixel in Abhängigkeit der Umgebungshelligkeit automatisch einstellbar ist.

Mit dieser Erfindung wird eine revolutionäre Qualitätsverbesserung von Anzeigevorrichtungen geschaffen. Die Bildqualität wird durch das Prinzip, die zwischen den Leuchtflächen liegenden nicht leuchtenden Flächen möglichst groß auszulegen, z.B. indem der Anteil der nicht leuchtenden Flächen an der gesamten Anzeigefläche mindestens 70% beträgt, erhöht, da hierdurch der Kontrast verbessert wird und viel Energie gespart werden kann, was insbesondere für tragbare Geräte sehr wichtig ist. Durch ein zusätzliches Vorsehen der nicht leuchtenden Flächen mit einem geringen Reflexionsgrad (spiegelnd oder diffus) werden schwarze Bildbestandteile auch schwarz bleiben. Um die hellen Bildbereiche noch heller machen zu können, und auch, um den Helligkeitsverlust durch die Verringerung des Flächenanteils der Leuchtflächen auszugleichen, werden spezielle intensive Lichtquellen (z.B. Laser oder micro-LEDs oder micro-OLEDS) verwendet oder es wird mittels spezieller Strahlformeinrichtungen, welche vom Betrachter aus gesehen hinter der Anzeigefläche liegen, eine Konzentration von Licht auf die Leuchtflächen und somit ein Helligkeits-Boost erreicht, so dass der Helligkeit-Mittelwert ähnlich ist wie auf normalen Display-Einrichtungen, jedoch mit besserem Kontrast und kleinerem Energieverbrauch, je nach Umgebungslicht.

### Bezugszeichen

- 1: Anzeigevorrichtung
- 2: Anzeigefläche der Anzeigevorrichtung
- 8: Substrat
- 9: nicht leuchtende Fläche
- 10: Pixel
- 11: Abstand
- 11.1: 1/3 des Abstands 11
- 12: Leuchtfläche
- 13: Streuelement
- 14: Farbfilterelement
- 20: Beleuchtungseinrichtung
- 21: Lichtquelle
- 22: aktive Leuchtfläche der Lichtquelle
- 30: optische Strahlformeinrichtung
- 31: optischer Konzentrator
- 32: Eingang des optischen Konzentrators
- 33: Ausgang des optischen Konzentrators
- 34: optischer Kollimator
- 35: optische Verluste
- 36: Ausgangswinkel des optischen Kollimator
- 37: Eingangswinkel des optischen Konzentrators
- 40.1: Funktionselement
- 40.2: Funktionselement / Solarelement
- 40.3: Funktionselement / Strahlformelement
- 40.4: Funktionselement / Strahldetektoreinrichtung
- 50: Betrachter
- 51: Einfallswinkel

## Patentansprüche

1. Farbanzeigevorrichtung (1) mit einer Anzeigefläche (2) mit einer Vielzahl von Pixeln, wobei die Anzeigefläche aus nicht leuchtenden Flächen (9) und Leuchtflächen (12) besteht, wobei jeweils eine Leuchtfläche (12) einem Pixel bestehend aus mehreren Farben zugeordnet ist, wobei die Anzeigefläche (2) eine dem Betrachter zugewandte Fläche der Anzeigevorrichtung (1) ist, wobei die Flächenschwerpunkte benachbarter Leuchtflächen (12) gegenseitige Abstände (11, 11.1) aufweisen, die maximal 190 µm betragen, wobei der Anteil der nicht leuchtenden Flächen (9) an der gesamten Anzeigefläche (2) mehr als 70% beträgt, und wobei die Anzeigevorrichtung (1) mindestens ein Funktionselement (40.1, 40.2, 40.3, 40.4) aufweist, wobei die Anzeigevorrichtung (1) ferner eine Beleuchtungseinrichtung (20) mit einem Substrat (8) aufweist, auf dem mindestens eine Lichtquelle (21) und das mindestens eine Funktionselement (40.1) angeordnet sind, wobei die Anzeigevorrichtung (1) ferner optische Strahlformeinrichtungen (30) aufweist, die zwischen der Beleuchtungseinrichtung (20) und der Anzeigefläche (2) angeordnet sind, und wobei jeder Strahlformeinrichtung (30) eine Leuchtfläche (12) zugeordnet ist und die Strahlformeinrichtungen (30) jeweils eingerichtet sind, Licht von der Beleuchtungseinrichtung (20) auf die jeweilige Leuchtfläche (12) zu konzentrieren, wobei jede optische Strahlformeinrichtung (30) mindestens eine gekrümmte oder abgestufte Reflektorfläche aufweist.

2. Farbanzeigevorrichtung (1) gemäß Anspruch 1, wobei die Flächenschwerpunkte benachbarter Leuchtflächen (12) gegenseitige Abstände (11, 11.1) aufweisen, die maximal 80 µm betragen, und wobei die Ausdehnung jeder Leuchtfläche höchstens 25 µm beträgt.

3. Farbanzeigevorrichtung (1) gemäß Anspruch 1 oder 2, wobei zumindest eine nicht leuchtende Fläche (9) ein weiteres Funktionselement (40.1, 40.2, 40.3, 40.4) aufweist.

4. Farbanzeigevorrichtung (1) gemäß einem der vorhergehenden Ansprüche, wobei das weitere Funktionselement (40.1, 40.2, 40.3, 40.4) zwischen zwei Leuchtflächen (12) und/oder das mindestens eine Funktionselement (40.1) zwischen zwei Lichtquellen (21) angeordnet ist

5. Farbanzeigevorrichtung (1) gemäß einem der vorhergehenden Ansprüche, wobei das weitere Funktionselement (40.1, 40.2, 40.3, 40.4) zwischen einer nicht leuchtenden Fläche (9) und einer Lichtquelle (21) angeordnet ist.

6. Farbanzeigevorrichtung (1) gemäß einem der vorhergehenden Ansprüche, wobei die nicht leuchtenden Flächen (9) der Anzeigefläche (2) durch Flächen eines Substrats und/oder durch Flächen eines Füllmaterials zwischen den Leuchtflächen (12) gebildet sind, wobei das Füllmaterial das weitere Funktionselement (40.1, 40.2, 40.3, 40.4) aufweist.

7. Farbanzeigevorrichtung (1) gemäß einem der vorhergehenden Ansprüche, wobei das weitere Funktionselement (40.1, 40.2, 40.3, 40.4) zwischen der Beleuchtungseinrichtung (20) und der Anzeigefläche (2) angeordnet ist.

8. Farbanzeigevorrichtung (1) gemäß einem der vorhergehenden Ansprüche, wobei das weitere Funktionselement (40.1, 40.2, 40.3, 40.4) zwischen mindestens zwei optischen Strahlformeinrichtungen (30) angeordnet ist, vorzugsweise in dem Raum zwischen zwei optischen Strahlformeinrichtungen (30).

9. Farbanzeigevorrichtung (1) gemäß einem der vorhergehenden Ansprüche, wobei das weitere Funktionselement (40.1, 40.2, 40.3, 40.4), das zwischen zwei optischen Strahlformeinrichtungen (30) angeordnet ist, eine polygone oder polyedrische Form aufweist, wobei die polygone oder polyedrische Form die Oberfläche der nicht leuchtenden Fläche (9) zwischen zwei Leuchtflächen (12) vergrößert.

10. Farbanzeigevorrichtung (1) gemäß einem der vorhergehenden Ansprüche, wobei das mindestens eine Funktionselement (40.3, 40.3) ein Strahlformelement (40.3) und eine Strahldetektoreinrichtung (40.4) aufweist, wobei das Strahlformelement Licht auf die Strahldetektoreinrichtung lenkt.

11. Farbanzeigevorrichtung (1) gemäß einem der vorhergehenden Ansprüche, wobei das mindestens eine Funktionselement (40.1, 40.2, 40.3, 40.4) ein Solarelement zum Umwandeln von Sonnenenergie in elektrische Energie und/oder einen Sensor aufweist, insbesondere einen zweidimensionalen und/oder dreidimensionalen Sensor, vorzugsweise einen Bildsensor oder einen berührungsempfindlichen Sensor, insbesondere ein Piezoelement.

## Claims

1. Colour display device (1) having a display area (2) with a plurality of pixels, wherein the display area consists of non-illuminated areas (9) and illuminated areas (12), wherein in each case one illuminated area (12) is assigned to one pixel consisting of multiple colours, wherein the display area (2) is an area of the display device (1) facing the viewer, wherein the centroids of adjacent illuminated areas (12) are located at distances (11, 11.1) of at most 190 µm from each other, wherein the proportion of non-illuminated areas (9) in the entire display area (2) is more than 70%, and wherein the display device (1) has at least one functional element (40.1, 40.2, 40.3, 40.4), wherein the display device (1) also has an illumination device (20) with a substrate (8) on which at least one light source (21) and the at least one functional element (40.1) are arranged, wherein the display device (1) also has optical beam-shaping devices (30) which are arranged between the illumination device (20) and the display area (2), and wherein an illuminated area (12) is assigned to each beam-shaping device (30) and the beam-shaping devices (30) are each set up to concentrate light from the illumination device (20) onto the respective illuminated area (12), wherein each optical beam-shaping device (30) has at least one curved or stepped reflector surface.

2. Colour display device (1) according to claim 1, wherein the centroids of adjacent illuminated areas (12) are located at distances (11, 11.1) of at most 80 µm from each other, and wherein the extent of each illuminated area is at most 25 µm.

3. Colour display device (1) according to claim 1 or 2, wherein at least one non-illuminated area (9) has a further functional element (40.1, 40.2, 40.3, 40.4).

4. Colour display device (1) according to any one of the preceding claims, wherein the further functional element (40.1, 40.2, 40.3, 40.4) is arranged between two illuminated areas (12) and/or the at least one functional element (40.1) is arranged between two light sources (21).

5. Colour display device (1) according to any one of the preceding claims, wherein the further functional element (40.1, 40.2, 40.3, 40.4) is arranged between a non-illuminated area (9) and a light source (21).

6. Colour display device (1) according to any one of the preceding claims, wherein the non-illuminated areas (9) of the display area (2) are formed by areas of a substrate and/or by areas of a filling material between the illuminated areas (12), wherein the filling material has the further functional element (40.1, 40.2, 40.3, 40.4).

7. Colour display device (1) according to any one of the preceding claims, wherein the further functional element (40.1, 40.2, 40.3, 40.4) is arranged between the illumination device (20) and the display area (2).

8. Colour display device (1) according to any one of the preceding claims, wherein the further functional element (40.1, 40.2, 40.3, 40.4) is arranged between at least two optical beam-shaping devices (30), preferably in the space between two optical beam-shaping devices (30).

9. Colour display device (1) according to any one of the preceding claims, wherein the further functional element (40.1, 40.2, 40.3, 40.4) which is arranged between two optical beam-shaping devices (30) has a polygonal or polyhedral shape, wherein the polygonal or polyhedral shape increases the surface area of the non-illuminated area (9) between two illuminated areas (12).

10. Colour display device (1) according to any one of the preceding claims, wherein the at least one functional element (40.3, 40.4) has a beam-shaping element (40.3) and a beam-detection device (40.4), wherein the beam-shaping element steers light onto the beam-detection device.

11. Colour display device (1) according to any one of the preceding claims, wherein the at least one functional element (40.1, 40.2, 40.3, 40.4) has a solar element for converting solar energy into electrical energy, and/or has a sensor, in particular a two-dimensional and/or three-dimensional sensor, preferably an image sensor or a touch-sensitive sensor, in particular a piezo element.

## Revendications

1. Dispositif d'affichage couleur (1) avec une surface d'affichage (2) avec une pluralité de pixels, dans lequel la surface d'affichage se compose de surfaces non lumineuses (9) et de surfaces lumineuses (12), dans lequel une surface lumineuse (12) est respectivement attribuée à un pixel composé de plusieurs couleurs, dans lequel la surface d'affichage (2) est une surface du dispositif d'affichage (1) tournée vers l'observateur, dans lequel les centres de gravité de surface de surfaces lumineuses (12) avoisinantes présentent des distances (11, 11.1) mutuelles qui s'élèvent au maximum à 190 µm, dans lequel la proportion des surfaces non lumineuses (9) par rapport à la totalité de la surface d'affichage (2) s'élève à plus de 70 %, et dans lequel le dispositif d'affichage (1) présente au moins un élément fonctionnel (40.1, 40.2, 40.3, 40.4), dans lequel le dispositif d'affichage (1) présente en outre un équipement d'éclairage (20) avec un substrat (8) sur lequel sont agencés au moins une source lumineuse (21) et le au moins un élément fonctionnel (40.1), dans lequel le dispositif d'affichage (1) présente en outre des équipements de forme de faisceau (30) optiques qui sont agencés entre l'équipement d'éclairage (20) et la surface d'affichage (2), et dans lequel une surface lumineuse (12) est attribuée à chaque équipement de forme de faisceau (30) et les équipements de forme de faisceau (30) sont respectivement aménagés de façon à concentrer une lumière depuis l'équipement d'éclairage (20) jusque sur la surface lumineuse (12) respective, dans lequel chaque équipement de forme de faisceau (30) optique présente au moins une surface de réflexion courbe ou en gradins.

2. Dispositif d'affichage couleur (1) selon la revendication 1, dans lequel les centres de gravité de surface de surfaces lumineuses (12) avoisinantes présentent des distances (11, 11.1) mutuelles qui s'élèvent au maximum à 80 µm, et dans lequel l'extension de chaque surface lumineuse s'élève au plus à 25 µm.

3. Dispositif d'affichage couleur (1) selon la revendication 1 ou 2, dans lequel au moins une surface non lumineuse (9) présente un autre élément fonctionnel (40.1, 40.2, 40.3, 40.4).

4. Dispositif d'affichage couleur (1) selon l'une des revendications précédentes, dans lequel l'autre élément fonctionnel (40.1, 40.2, 40.3, 40.4) est agencé entre deux surfaces lumineuses (12) et/ou le au moins un élément fonctionnel (40.1) est agencé entre deux sources lumineuses (21).

5. Dispositif d'affichage couleur (1) selon l'une des revendications précédentes, dans lequel l'autre élément fonctionnel (40.1, 40.2, 40.3, 40.4) est agencé entre une surface non lumineuse (9) et une source lumineuse (21).

6. Dispositif d'affichage couleur (1) selon l'une des revendications précédentes, dans lequel les surfaces non lumineuses (9) de la surface d'affichage (2) sont formées par des surfaces d'un substrat et/ou par des surfaces d'un matériau de remplissage entre les surfaces lumineuses (12), dans lequel le matériau de remplissage présente l'autre élément fonctionnel (40.1, 40.2, 40.3, 40.4).

7. Dispositif d'affichage couleur (1) selon l'une des revendications précédentes, dans lequel l'autre élément fonctionnel (40.1, 40.2, 40.3, 40.4) est agencé entre l'équipement d'éclairage (20) et la surface d'affichage (2).

8. Dispositif d'affichage couleur (1) selon l'une des revendications précédentes, dans lequel l'autre élément fonctionnel (40.1, 40.2, 40.3, 40.4) est agencé entre au moins deux équipements de forme de faisceau (30) optiques, de préférence dans l'espace entre deux équipements de forme de faisceau (30) optiques.

9. Dispositif d'affichage couleur (1) selon l'une des revendications précédentes, dans lequel l'autre élément fonctionnel (40.1, 40.2, 40.3, 40.4) qui est agencé entre deux équipements de forme de faisceau (30) optiques présente une forme polygonale ou polyédrique, dans lequel la forme polygonale ou polyédrique agrandit la surface de la surface non lumineuse (9) entre deux surfaces lumineuses (12).

10. Dispositif d'affichage couleur (1) selon l'une des revendications précédentes, dans lequel le au moins un élément fonctionnel (40.3, 40.4) présente un élément en forme de faisceau (40.3) et un équipement de détection de faisceau (40.4), dans lequel l'élément en forme de faisceau est orienté vers l'équipement de détection de faisceau.

11. Dispositif d'affichage couleur (1) selon l'une des revendications précédentes, dans lequel le au moins un élément fonctionnel (40.1, 40.2, 40.3, 40.4) présente un élément solaire pour la conversion d'une énergie solaire en une énergie électrique et/ou un capteur, en particulier un capteur bidimensionnel et/ou tridimensionnel, de préférence un capteur d'image ou un capteur sensible au toucher, en particulier un élément piézo.
